# EUROPEAN PATENT SPECIFICATION

(11) **EP 0 431 527 B1**
(45) Date of publication and mention of the grant of the patent: **15.03.1995**
(21) Application number: 90123116.7
(22) Date of filing: 03.12.1990
(51) Int. Cl.: G02B 6/12, G02B 6/34

(54) **Optical coupling device using wavelength selective optical coupler**
Optisches Kopplergerät mit wellenlängeselektivem optischem Koppler
Dispositif de couplage optique à coupleur optique sélectif de longueur d'ondes

(30) Priority: 04.12.1989 JP 314841/89; 26.02.1990 JP 45084/90
(43) Date of publication of application: 12.06.1991
(73) Proprietor: CANON KABUSHIKI KAISHA, Tokyo (JP)
(72) Inventor: Sakata, Hajime, Ohta-ku, Tokyo (JP); Oda, Hitoshi, Ohta-ku, Tokyo (JP)
(74) Representative: Pellmann, Hans-Bernd, Dipl.-Ing.

(56) References cited:
- EP-A- 0 187 979
- JOURNAL OF LIGHTWAVE TECHNOLOGY, vol. LT-5, no. 2, February 1987, New York, US, pp. 268-273 ; D. MARCUSE : "Directional Couplers Made of Nonidentical Asymmetric Slabs. Part II : Grating-Assisted Couplers"
- PATENT ABSTRACTS OF JAPAN, vol. 13, no. 349 P-911)(3697), 7 August 1989 ; & JP-A-1 107 214
- OPTICAL ENGINEERING, vol. 19, no. 4, August 1980, Bellingham, US, pp. 581-586 ; J.L. MERZ : "III-V Heterostructure Devices For Integrated Optics"

## Description

### BACKGROUND OF THE INVENTION

### Field of the Invention

The present invention relates to an optical coupling device such as optical filter, photodetector, semiconductor laser, or optical amplifier, using a wavelength selective optical coupler comprising two waveguides coupled by a diffraction grating.

### Related Background Art

A conventional wavelength selective optical coupler consisted of two optical waveguides formed on the same substrate, as described in R.C. Alferness et al.: Applied Physics Letters, 33, P161 (1978), Japanese Laid-Open Patent Application No. 61-250607, or Miki et al., Electronic Communications Institute study report OQE81-129, for example.

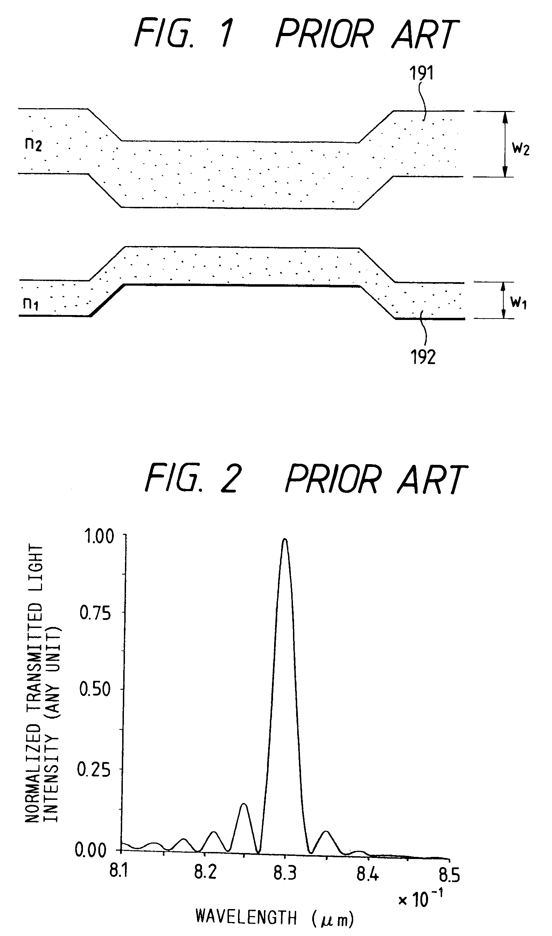

Fig. 1 shows the construction of such a conventional wavelength selective optical coupler. In the same figure, two waveguides 191, 192 are formed with line widths or heights W₁, W₂, and refractive indexes n₁, n₂, which are different from each other, as shown. Thus, they have also different distribution relations between the wavelength of guided light propagating through the respective optical waveguide 191, 192 and the propagation constant. Then the propagation constants of two waveguides coincide for guided light on a specific range of wavelength, and the optical coupling takes place between two waveguides 191, 192. In other words, only the light within the specific range of wavelength is selected, and the optical power can be transferred between the waveguides 191, 192.

Such an optical coupler has been used for an optical filter which performs the multiplexing or demultiplexing of waves between the signal light and the light of specific wavelength by using the transfer of this optical power.

However, the optical filter as above mentioned had a spectral transmittivity characteristic containing non-negligible side lobes on both sides of the transmission band (main lobe) including the central wavelength, as shown in Fig. 2. The existence of side lobe brought about cross-talk of optical signals when this optical filter was used in an optical communication system of wavelength division multiplexing method. If there is provided a sufficient separation of wavelengths to avoid the cross talk, the number of communication channels is decreased. The side lobe of the filtering characteristic on such an optical coupler was a factor preventing the enhancement of performance of an optical device using this optical coupler.

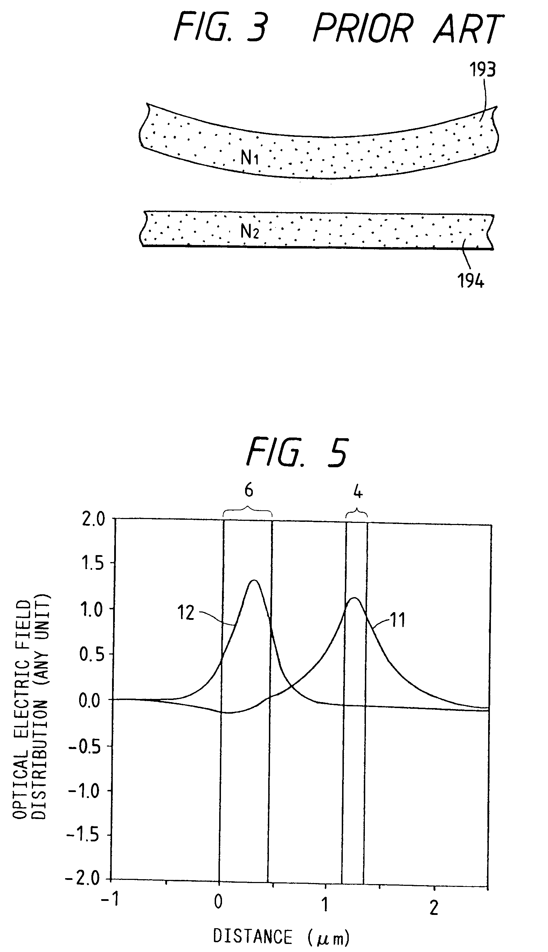

A method for suppressing the side lobe as above mentioned, in which the interval between the waveguides 193, 194 constituting the optical coupler is gradually changed as shown in Fig. 3, was proposed in R.C. Alferness et al.: IEEE Journal of Quantum Electronics, QE-14, No. 11, p. 843 (1978).

However, this method had the disadvantage that it was difficult to form the waveguide 193 curvilinearly, and further difficult to manufacture the optical coupler if it would be a type of laminating waveguides in the direction of thickness.

"Journal of Lightwave Technology", vol. 5, no. 2, pages 268-273, D. Marcuse, "Directional Couplers Made of Non-identical Asymmetric Slabs. Part II: Grating-Assisted Couplers" discloses an optical device, in particular, a directional coupler wherein a complete power exchange between two slab waveguides irrespective of different propagation constants of their modes is achieved by means of a diffraction grating.

By the way, an optical coupler having a sharp wavelength selectivity and little loss of quantity of light was proposed in R.C. Alferness et al., "Integrated and Guided-Wave Optics" 1989 technical digest series vol. 4, pp 215-218. This optical coupler had two guiding layers with different guided modes from each other laminated on a substrate and coupled optically by a diffraction grating. The present inventor has proposed an optical device using this optical coupler in U.S.S.N. 491,203 filed on March 9, 1990.

### SUMMARY OF THE INVENTION

An object of this invention is to provide an optical coupling device which operates more efficiently by further improving the above mentioned wavelength selective optical coupler using a diffraction grating, and suppressing the side lobe of the filtering characteristic.

According to the invention this object is accomplished by an optical coupling device comprising: a substrate: a first guiding layer provided on said substrate; a second guiding layer laminated with said first guiding layer on said substrate, the propagation constant of the guided mode in said second guiding layer being different from that of the guided mode in said first guiding layer, said first and second guiding layers being arranged so as to define a propagation direction for light in said guiding layers, and being disposed such that there is an area in which said guided modes overlap; and a diffraction grating provided in said area of overlap, said diffraction grating acting to couple light of a specific wavelength range propagating through said first guiding layer into said second guiding layer, said diffraction grating comprising regions of high refractive index and regions of low refractive index disposed periodically in said light propagation direction; characterized in that the ratio between the width of the high refractive index region and the width of the low refractive index region within a period of said diffraction grating changes gradually along said light propagation direction.

The advantages of the invention will become apparent and obvious to those skilled in the pertinent art upon referring to the following description provided in connection with the accompanying drawings, of which:

### BRIEF DESCRIPTION OF THE DRAWINGS

Fig. 1 is a schematic view showing a first example of a conventional wavelength selective optical coupler,
Fig. 2 is a view showing the spectral tramsmittivity characteristic on an optical filter using the example of Fig. 1,
Fig. 3 is a schematic view showing a second example of a conventional wavelength selective optical coupler,
Fig. 4 is a schematic cross-sectional view showing a first embodiment of an optical coupling device according to this invention,
Fig. 5 is a view showing the optical electric field distribution for each guided mode in the first embodiment,
Fig. 6 is a view showing the relation between the groove width/grating pitch and the coupling coefficient,
Fig. 7 is a view showing the spatial change of the coupling coefficient for the grating in the first embodiment,
Fig. 8 is a view showing the filter spectrum in the first embodiment,
Fig. 9 is a view showing the filter spectrum of a conventional diffraction grating,
Fig. 10 is a schematic perspective view showing a second embodiment according to this invention,
Fig. 11 is a view showing the spatial change of the coupling coefficient for the grating in the second embodiment,
Fig. 12 is a view showing the filter spectrum in the second embodiment,
Fig. 13 is a cross-sectional side view showing a third embodiment according to this invention,
Fig. 14 is a view showing the wavelength characteristic of electric signal detected in the third embodiment,
Fig. 15 is a cross-sectional side view showing a fourth embodiment according to this invention,
Fig. 16 is a view showing the filter spectrum in the fourth embodiment,
Fig. 17 is a schematic perspective view showing a fifth embodiment according to this invention,
Fig. 18 is a schematic perspective view showing a sixth embodiment according to this invention,
Fig. 19 is a cross-sectional side view showing a seventh embodiment according to this invention,
Fig. 20 is a cross-sectional front view showing the seventh embodiment according to this invention,
Fig. 21 is a cross-sectional front view showing an eighth embodiment to this invention,
Fig. 22 is a cross-sectional side view showing the eighth embodiment according to this invention,
Fig. 23 is a cross-sectional side view showing a ninth embodiment according to this invention,
Fig. 24 is a partial cross-sectional perspective view showing a tenth embodiment according to this invention,
Fig. 25 is a view showing the distribution of coupling coefficient in the propagation direction of light in the tenth embodiment,
Fig. 26 is a view showing the relations between the duty ratio and the pitch and coupling coefficient in the tenth embodiment,
Fig. 27 is a view showing the change of the duty ratio in the propagation direction of light in the tenth embodiment,
Fig. 28 is a view showing the change of the grating pitch in the propagation direction of light in the tenth embodiment,
Fig. 29 is a view showing the characteristic of the band pass filter in the tenth embodiment,
Fig. 30 is a view showing the characteristic of the notch filter in the tenth embodiment,
Figs. 31 and 32 are views showing other examples of the relations between the duty ratio of the grating and the pitch and coupling coefficient,
Fig. 33 is a view showing the relation between the grating depth and the coupling length,
Fig. 34 is a cross-sectional side view showing an eleventh embodiment according to this invention, and a view showing the change of the coupling coefficient, and
Fig. 35 is a view showing the characteristic of the band pass filter in the eleventh embodiment.

### DESCRIPTION OF THE PREFERRED EMBODIMENTS

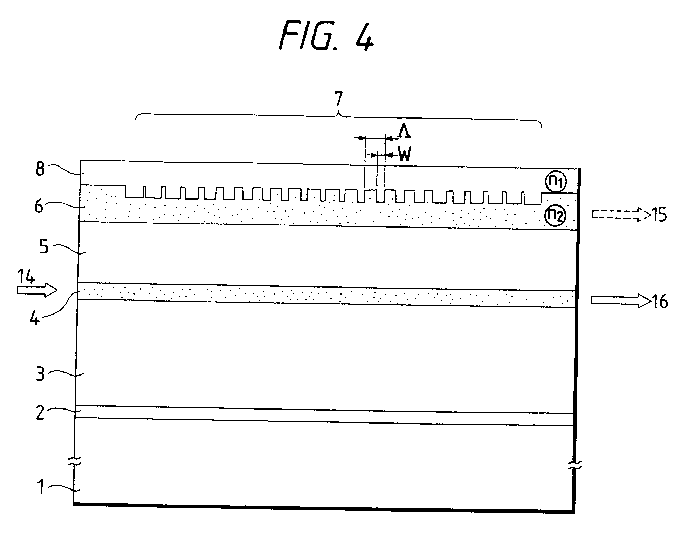

Referring now to Fig. 4, there is shown a construction of a first embodiment according to this invention. The present embodiment has, grown in sequence by molecular beam epitaxy (MBE) on a substrate 1 of GaAs, a buffer layer 2 of GaAs, 0.5 »m thick, a cladding layer 3 of Al_{0.5}Ga_{0.5}As, 1.5 »m thick, a first guiding layer or first waveguide 4, 0.1 »m thick, which is made a multiple quantum well (MQW) by laminating GaAS and Al_{0.4}Ga_{0.6}As alternatively, a cladding layer 5 of Al_{0.5}Ga_{0.5}As, 0.8 »m thick, and a second guiding layer or second waveguide 6, 0.4 »m thick, which is made a MQW by laminating GaAs and Al_{0.2}Ga_{0.8}As alternatively. Then after making a resist mask by photolithography using a photoresist, a diffraction grating or grating 7 consisting of corrugation 0.07 »m in depth is formed in portions on an upper surface of the second waveguide 6 by reactive ion beam etching (RIBE).

In this embodiment, in order to suppress the side lobe of the filter spectrum, the coupling coefficient of the grating 7 is changed almost symmetrically along the traveling direction of light from its central portion toward the incident and propagation sides of light. In other words, the pattern of the grating 7 is changed, as shown in Fig. 4, by making the pitch Λ constant and changing the proportion of ridge to groove (or line to space) constituting the grating 7 along the progressive direction of light. The ridge is a portion of high refractive index n₂, while the groove is a portion of low refractive index n₁.

After forming the grating 7, the SiO₂ layer 8 is coated on the grating 7 by sputtering. Then after applying a photoresist again, and making a pattern of a stripe extending in the propagation direction of light for laterally confining the guided light, a wafer is etched by RIBE, to a position where the GaAs substrate 1 is exposed, in which a leading edge of stripe is cut obliquely to the progressive direction of light to couple the light to only the first waveguide 4 when the light enters.

Then Al_{0.5}Gag_{0.5}As is grown, by liquid phase epitaxy (LPE), to embed the stripe, and SiO₂ is coated again over the entire surface. Consequently, a structure with two waveguides 4, 6 laminated as shown in Fig. 4 can be obtained.

In this way, the optical wavelength filter of this embodiment has two layers of waveguides (first waveguide 4, second waveguide 6) laminated in the layer direction, thereby constituting a directional coupler. As each waveguide 4, 6 is formed to have a different thickness or composition, it has a different propagation constant for light propagating through it. The grating 7 formed on the second waveguide 6 is used to select a wavelength to be coupled optically, the wavelength can be selected by changing the pitch Λ or the ratio of ridge to groove.

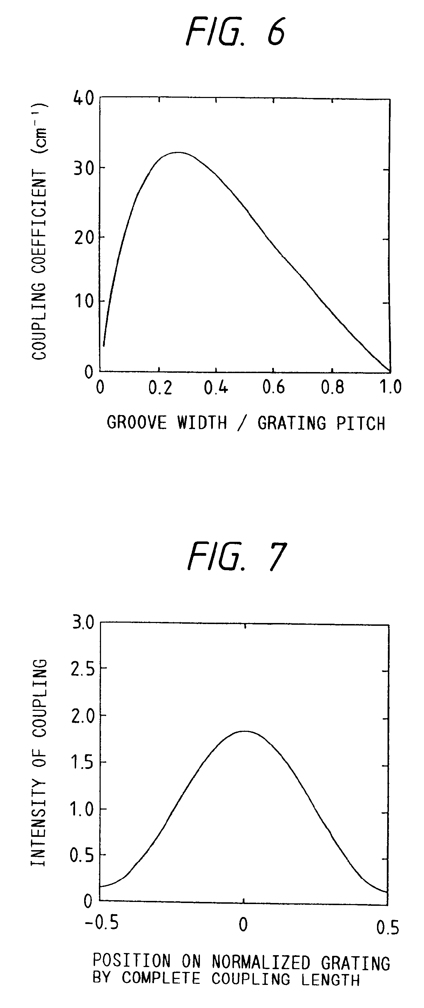

Fig. 5 shows the optical electric field distribution in the guided modes of this embodiment. The vertical axis is the optical electric field intensity distribution, while the horizontal axis is the distance in the lamination direction with reference to the upper surface of the second waveguide 6. Thus, there are two guided modes in the waveguides 4, 6 of this embodiment, i.e., the odd mode 11 which is centred on the first waveguide 4, and the even mode 12 which is centred on the second waveguide 6. The grating 7 is formed in an overlapping portion (left portion of the second waveguide 6 in Fig. 5) of the odd mode 11 and the even mode 12, as above described.

The operation of this embodiment will be described.

The incident light 14 multiplexed in wavelength ranging from 0.8 »m to 0.86 »m is coupled for input to the first waveguide 4, as shown in Fig. 4. There are two guided modes which are centred on the two waveguides 4, 6 i.e., the even mode 12 and the odd mode 11, as previously described. The incident light 14 input to the first waveguide 4 propagates in the odd mode 11 that is centred on the first waveguide 4. As the odd mode 11 and the even mode 12 have different propagation constants, the light propagates nearly independently almost without coupling at the area where the grating 7 does not exist. However, at the area where the grating 7 exists, the transfer of optical power occurs if the following relation is satisfied between the propagation constant β _{odd} for the odd mode 11 and the propagation constant β ₑᵥₑₙ for the even mode 12.${\text{β}}_{\text{even}} {\text{(λ) - β}}_{\text{odd}} \text{(λ) = 2π/Λ}$
Where λ is the wavelength of light, and Λ is the pitch of the grating 7.

If the transfer of optical power occurs as described above, the guided light in the odd mode 11 to which the incident light 14 is coupled can be converted into guided light in the even mode 12. Accordingly, the incident light 14 finally becomes an optical wave propagating through the second waveguide 6, and is output as the selected output light 15. Light with other wavelengths is output from the first waveguide 4 as the unselected output light 16.

A coupling coefficient g is defined, which is a coefficient expressing the coupling intensity of optical waves propagating through two waveguides 4, 6. The coupling coefficient g is given by the following expression.${\text{g = ∫ ε}}_{\text{even}} {\text{(x)·A₁(x)·ε}}_{\text{odd}} \text{(x)dx}$
Where ε ₑᵥₑₙ, ε _{odd} is the optical electric field distribution in the even or odd mode, respectively, and A₁ is the component of the Fourier series corresponding to the primary diffracted light for the grating 7. Assuming that the ridge and groove of the grating 7 are rectangular, A₁(x) is given by the following expression: 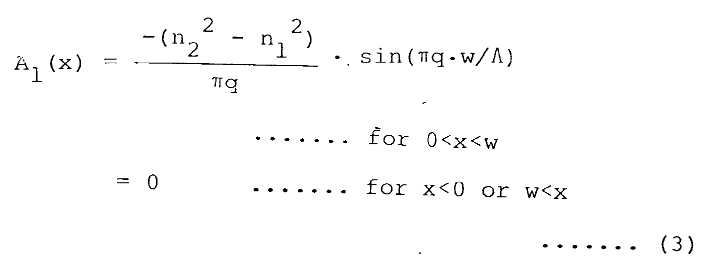
where q=1 as the coupling of β ₑᵥₑₙ and β _{odd} is performed by the primary diffracted light, n₁ and n₂ are the refractive indices of the materials constituting the ridge and groove of the grating 7, respectively, Λ is the pitch of the grating 7, and w is the groove width. In other words, the coupling coefficient g depends on the ratio of ridge to groove occupied in the pitch Λ of the grating 7. Fig. 6 is a graph representing the change of the coupling coefficient g when the ratio of ridge to groove in the grating 7 is changed in a directional coupler type optical filter in accordance with the configuration of this embodiment. In the embodiment as shown, the intensity of coupling is at a maximum near the position where the ratio of ridge to groove is 0.75 : 0.25, and decreases before or beyond that position. However, the ratio of ridge to groove at which the intensity of coupling is at a maximum depends on the configuration of waveguide.

Thus, in this embodiment, in order to perform the wavelength filtering with light having a central wavelength of 0.83 »m, the pitch Λ is set to be 7.8 »m according to the expression (1), and the ratio of ridge to groove constituting the grating 7 is configured as shown in Fig. 4. In other words, the ratio of ridge to groove is 0.7 : 0.3 in the center of the grating area, the groove gradually increasing in proportion toward the ends, and the ratio is 0.1 : 0.9 at both ends. In this way, the coupling coefficient or the intensity of coupling is changed in the same way as a conventional example as shown in Fig. 3, by gradually changing the ratio of ridge to groove from the center of grating toward the ends.

Here, the length of coupling or the complete coupling length is defined to exemplify the distribution for the intensity of coupling. Assuming that the progressive direction of guided light is the z direction, the complete coupling length is L, and the coupling coefficient which changes in the z direction is G(z), the following expression is satisfied. 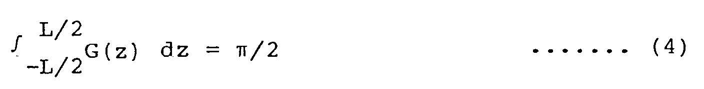
Where the function for distribution G(z) is referred to as a Taper function, which is set to be F(z), and the following expression is obtained,$\text{G(z) = G₀ · F(z)}$
(G₀ is a constant)
Note that F(z) is normalized with L, i.e., the following expression is satisfied, 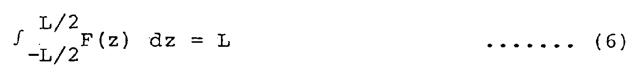
From the expressions (4), (5) and (6), the complete coupling length L can be obtained as in the following.$\text{G₀ L = π/2}$$\text{∴ L = π/(2 G₀)}$
As G₀ is 21.5 cm⁻¹ in this embodiment, the complete coupling length L is 730 (»m). Thus it is assumed in this embodiment that the complete coupling length L is 730 »m, and the Taper function F(z) for representing the distribution of the intensity of coupling is a Hamming function as shown in Fig. 7. This Hamming function is expressed as in the following.$\text{F(z) = 1 + 0.852 · cos (2π z/L)}$

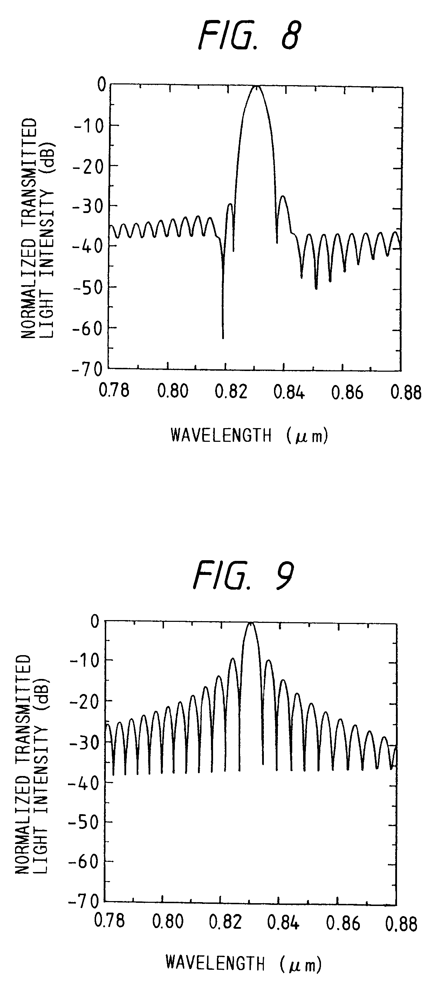

With the above configuration, the intensity (filter spectrum) of selected output light 15 to be output from the second waveguide 6 among the light 14 incident upon the first waveguide 4 is as shown in Fig. 8. For comparison, the spectrum of an example is shown in Fig. 9, in which the ratio of ridge to groove of the grating is constant, and the intensity of coupling is made constant over the whole area where the grating 7 was formed. With the comparison between Fig. 8 and Fig. 9, it should be understood that the suppression effect of the side lobe can be sufficiently obtained with the configuration of this embodiment. From the filter spectrum as shown in Fig. 8, it will be seen that the full width at half maximum is 55 Å and the ratio of the transmitted light intensity on the central wavelength of main lobe to that on the wavelength 100 Å off that central wavelength is about 30 dB. In the configuration of Fig. 4, it should be noted that an anti-reflection coating of ZrO₂ is applied on the input and output end faces to suppress the decrease of efficiency and the occurrence of ripples accompanied by the reflection upon the end faces.

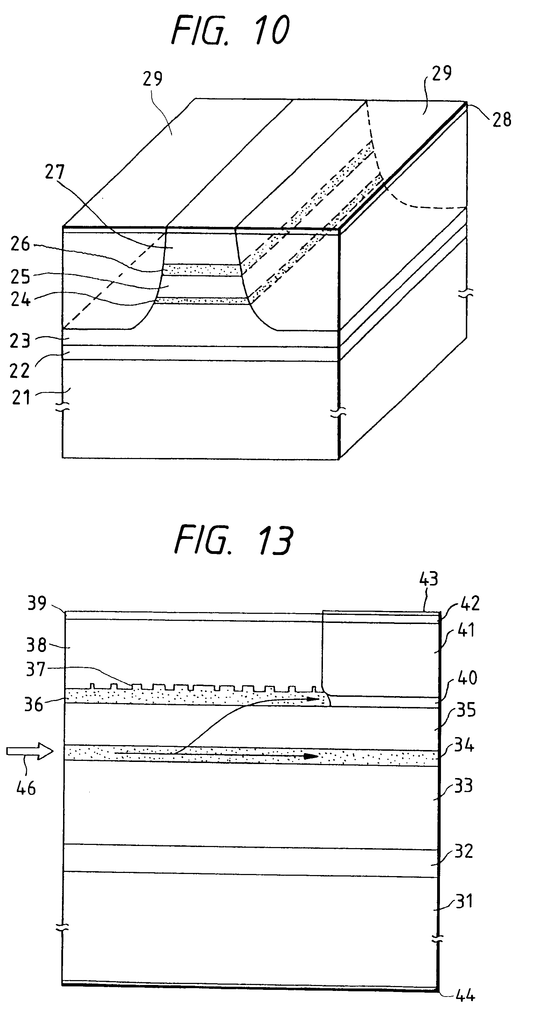

Fig. 10 shows a second embodiment. The second embodiment, in the same way as the first embodiment, has, grown in sequence by molecular beam epitaxy (MBE) on a GaAs substrate 21, a buffer layer 22 of GaAs, 0.5 »m thick, a cladding layer 23 of Al_{0.5}Ga_{0.5}As, 1.5 »m thick, a first guiding layer 24, 0.15 »m thick, which is made a multiple quantum well (MQW) by laminating GaAs and Al_{0.4}Ga_{0.6}As alternatively, a cladding layer 25 of Al_{0.5}Ga_{0.5}As, 0.9 »m thick, and a second guiding layer 26, 0.5 »m thick, which is made a MQW by laminating GaAs and Al_{0.2}Ga_{0.8}As alternatively. Then by the photoresist and RIBE method, a grating (not shown) consisting of a corrugation 0.3 »m deep is formed on the second guiding layer 26, and then by LPE, the layer of Al_{0.5}Ga_{0.5}As is regrown to embed the groove of the grating. Subsequently, a GaAs layer is grown as a cap layer 28, and after forming the stripe with SiO₂, impurities such as Zn (or Si) are placed on both sides of the stripe, by thermal diffusion, to confine the light in the transverse direction. Thereby the first waveguide 24 and the second waveguide 26 have both their sides disordered, where a region 29 with a low refractive index is formed, so that the optical wavelength filter as shown in Fig. 10 is made.

With the low refractive index region 29 formed on both sides of the first waveguide 24 and the second waveguide 26, the guided light is confined in the transverse direction, to reduce the loss due to the diffraction spreading of the guided light, which results in a highly efficient optical wavelength filter.

The confinement in the transverse direction can be applied in various ways such as the method of forming ridges or the loading method, besides the method as described in the first and second embodiments.

In the second embodiment, the ratio of ridge (high refractive index region) to groove (low refractive index region) constituting the grating is changed from 0.6 : 0.4 to 1.0 from the center to the ends to increase the ratio of ridge.

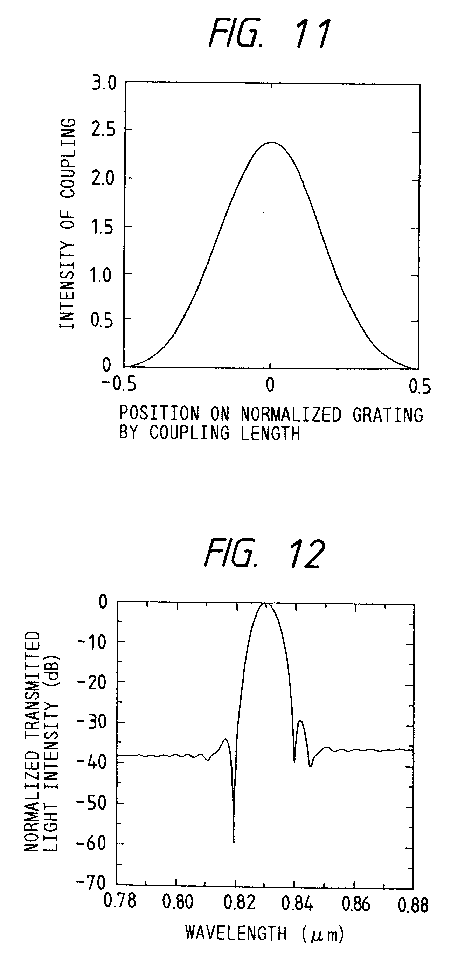

With this configuration, the change of the coupling coefficient on the grating area follows the shape of a Blackman function, as shown in Fig. 11. The Blackman function F(z) is expressed as in the following.$\text{F(z) = 1 +1.19 cos (2πz/L) + 0.19 cos (4πz/L)}$

From the filter spectrum of the second embodiment as shown in Fig. 12, it is seen how the side lobe is suppressed. The full width at half maximum is 73 Å, and the ratio of the transmittivity on the central wavelength of the main lobe to that on the wavelength 100 Å off that central wavelength is from 30 dB to 35 dB or more.

By the way, besides the Taper function for the coupling coefficient in the first and second embodiments, the following distribution is provided. That is, the coupling coefficient can be given in the propagation direction of light by the raised cosine function,$\text{F(z) = 1 + cos (2πz/L)}$
or the Kaiser function${\text{F(z) = [γ/sinh(γ)] I₀ (γ{1 - (2z/L)²}}}^{\text{1/2}} \text{)}$
If the grating with a distribution in accordance with the above function is formed, the side lobe can be also suppressed. Here L is the complete coupling length, z is the position along the waveguide in -L/2 ≦ z ≦ L/2, γ is an arbitrary number, and I₀ is the zero order value of the Bessel function of the first kind.

In the above embodiment, the grating is formed on the second waveguide 6, 26, but the grating may be made at any portions where the optical electric field distributions (even mode 12, odd mode 11) of the guided light both exist. However, as the coupling coefficient changes with it, the complete coupling length L must be correspondingly adjusted.

Each of the above embodiments was constructed from GaAs/AlGaAs materials, but it is clear that they can be also constructed from other materials, such as compound semiconductors of InGaAs/InGaP, glass materials of SiO₂/TiO₂, or optical crystals of LiNbO₃, LiTaO₃, and BSO.

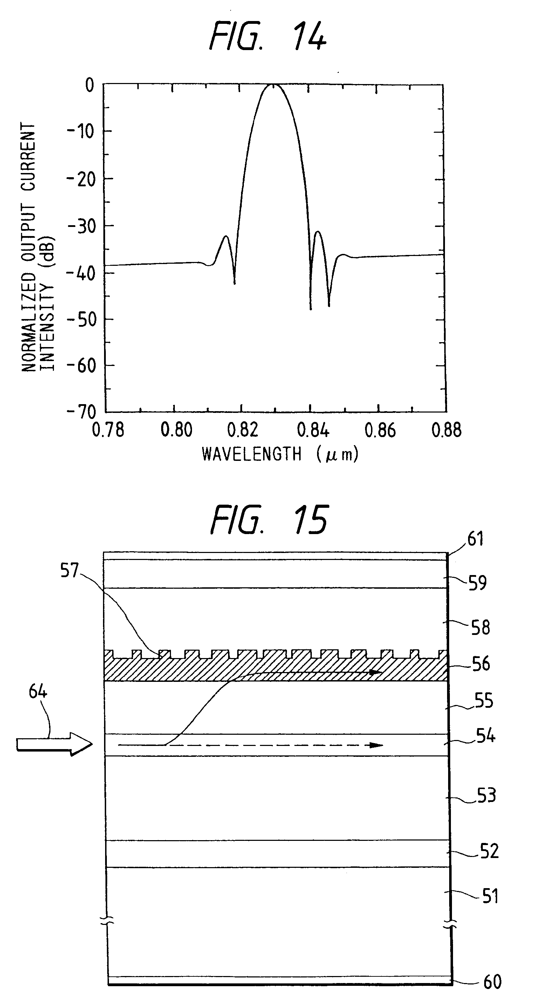

Fig. 13 shows the third embodiment according to this invention. This embodiment was embodied by integrating photodetectors having selectiveness of wavelength, with the construction of the optical wavelength filter as previously described.

The third embodiment has, grown in sequence by molecular beam epitaxy (MBE) on a substrate 31 of n⁺-GaAs, a buffer layer 32 of n-GaAs, 0.5 »m thick, a cladding layer 33 of n-Al_{0.5}Ga_{0.5}As, 1.5 »m thick, a first waveguide 34 of n-Al_{0.3}Ga_{0.7}As, 0.2 »m thick, a cladding layer 35 of n-Al_{0.5}Ga_{0.5}As, 0.8 »m thick, and a second waveguide 36, 0.4 »m thick, which is made a MQW by laminating i-GaAs and i-Al_{0.4}Ga_{0.6}As alternatively. Then by photolithography, a grating 37 of corrugation, 0.05 »m in depth, 7.7 »m in pitch Λ, with the ratio of ridge to groove changing in the traveling direction of light in accordance with the Kaiser function (expression (8) as shown above), was formed on the upper surface of the second waveguide 36 over a length of 1.277 mm.

Then by liquid phase epitaxy (LPE), a cladding layer 38 of i-Al_{0.5}Ga_{0.5}As, and a cap layer 39 of i-GaAs, 0.5 »m thick, are regrown on that surface. Thereafter, the cladding layer 38 and the second waveguide 36 in the region adjacent to the grating 37 are removed by etching. Further, by LPE, an absorption layer 40 of i-GaAs, 0.1 »m thick, a cladding layer 41 of p-Al_{0.5}Ga_{0.5}As, 1.2 »m thick, and a cap layer p⁺-GaAs, 0.5 »m thick are regrown on that removed area, and subsequently, an electrode 43 consisting of Cr/Au is formed on the cap layer 42, and an electrode 44 consisting of AuGe/Au is formed on the back surface of the substrate 31.

In this embodiment, only the light having the wavelength selected by the optical wavelength filter from the light 46 incident upon the first waveguide 34 is coupled to the second waveguide 36, and absorbed in the absorption layer 40, which is a photodetection portion. The photodetection portion has a p-i-n structure, and a reverse bias is applied between the electrodes 43, 44. Therefore, carriers caused by the absorption are detected as an electric current signal.

Fig. 14 is a view showing the wavelength characteristic of signal light to be taken out as electric signals in this embodiment. The full width at half maximum, i.e., the band width of -3dB that is a wavelength selective characteristic, is about 78Å. The ratio of output current at the central wavelength of the main lobe to that of the wavelength 100Å off that central wavelength (or cross talk between wavelengths) is about 30dB, which indicates that the side lobe is sufficiently suppressed.

Fig. 15 is a view showing the construction of the fourth embodiment according to this invention. This fourth embodiment has grown in sequence on the substrate 51 of n⁺-GaAs by molecular beam epitaxy (MBE), a buffer layer 52 of n-GaAs, 0.5 »m thick, a cladding layer 53 of n-Al_{0.5}Ga_{0.5}As, 1.5 »m thick, a waveguide 54, 0.2 »m thick, which is made a multiple quantum well (MQW) by laminating n-GaAs, 30Å thick and Al_{0.5}Ga_{0.5}As, 70Å thick, alternatively, a cladding layer 55 of n-Al_{0.5}Ga_{0.5}As, 0.7 »m thick, and a light absorption layer 56 of i-GaAs, 0.4 »m thick.

Then by photolithography using a photoresist, a resist mask is made, the upper surface of the light absorption layer 56 is etched by using ammonia and hydrogen peroxide, and then a grating 57 consisting of corrugation was formed over a length of 100 »m, in which the grating had a depth 0.2 »m, a pitch 5.5 »m, and the ratio of ridge to groove of the grating 57 changing in the traveling direction of light in accordance with the raised cosine function as shown above in the expression (7).

Then by liquid phase epitaxy (LPE), a cladding layer 58 consisting of p-Al_{0.5}Ga_{0.5}As is regrown, and further a cap layer 59 consisting of p⁺-GaAs is regrown. Finally, a contact layer (not shown) consisting of Au-Ge and an electrode 60 of Au are coated on the back surface of the substrate 51, and a contact layer (not shown) and an electrode 61 of Au are coated on an upper surface of the cap layer 59. In this way, a photodetector which is a p-i-n type photodiode was made. The photodetector of this embodiment is constructed as above shown so that the waveguide 54 and the light absorption layer 56 laminated in the layer direction form a directional optical coupler. As the waveguide 54 and the light absorption layer 56 have different compositions and thicknesses of layer, the propagation constants of light propagating through each layer are different. The grating 57 formed on the upper surface of the light absorption layer 56 is used to select the light with which the directional coupling is performed by changing the pitch Λ of the grating and the ratio of ridge to groove.

The operation of this embodiment is described in the following. A reverse bias is applied between electrodes 60, 61 of this embodiment, and the signal light 64 which consists of light having a wavelength ranging from 0.78 »m to 0.88 »m at intervals of wavelength 0.01 »m is coupled to the waveguide 54 by the end face coupling. The input signal light 64 propagates in the odd mode 11 having its intensity centred on the waveguide 54, wherein either the even or odd mode 11, 12 exists within the optical coupler as shown in Fig. 5. As the optical electric intensity distribution of this odd mode 11 does not reach to the light absorption layer 56 almost entirely, as shown in Fig. 5, the propagation loss due to the absorption in the absorption layer 56 is quite little.

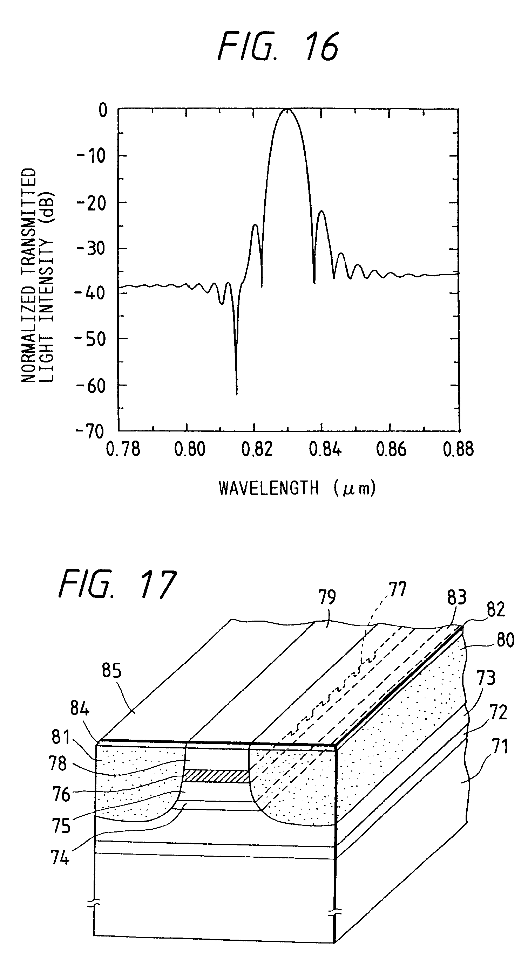

If the relation as expressed in (1) is satisfied at the specific wavelength as above described, the light of the odd mode 11 is converted into that of the even mode 12, and the central intensity transfers to the light absorption layer 56. In this embodiment, the grating pitch Λ is 5.5 »m, and the wavelength of 0.83 »m is detected. Thus the guided light transferred into the light absorption layer 56 is absorbed, creating electrons and holes, which are detected externally as a photoelectric current. Fig. 16 is a view showing the wavelength distribution of the light detected in this embodiment. It will be seen how a sharp selection is performed with the side lobe sufficiently suppressed with a full width at half maximum of 64Å.

In this embodiment, the grating 57 was formed over a length of 100 »m, which is a length less than the complete coupling length L 262 »m (the length of the coupling area where the coupling efficiency is at maximum) of the directional coupler, this is because the responsivity of the photodetector has been taken into consideration. Therefore, if the responsivity may be degraded due to the increased reception area of light, the absorption efficiency of light is further increased by making the length of the grating area closer to the complete coupling length L.

If a plurality of elements of this embodiment are connected in tandem by changing the pitch Λ of the grating and the ratio of the ridge to groove, an integrated photodetector which allows the simultaneous detection of signal lights having a plurality of wavelengths can be also made.

Fig. 17 is a view showing a fifth embodiment according to this invention. This embodiment has a p-i-n structure formed in a horizontal type for photodetection.

The structure of this embodiment has, in sequence coated on a substrate 71 of semi-insulating GaAs, a buffer layer 72 of thickness 0.5 »m consisting of i-GaAs, a cladding layer 73 of thickness 1.5 »m consisting of i-Al_{0.5}Ga_{0.5}As, a waveguide 74 of thickness 0.2 »m which is made a multiple quantum well (MQW) by laminating i-GaAs layer of thickness 50Å and Al_{0.5}Ga_{0.5}As layer alternatively, a cladding layer 75 of thickness 0.75 »m consisting of i-Al_{0.5}Ga_{0.5}As, and a light absorption layer 76 of thickness 0.3 »m consisting of i-GaAs. Then in the same process as for the fourth embodiment as shown in Fig. 15, a corrugation-like grating 77 of 0.05 »m depth tapered to the intensity of coupling is made on the upper surface of the light absorption layer 76. The pitch of corrugation was 4.6 »m, and the length of the grating area was 200 »m. Thereafter, a cladding layer 78 of thickness 1.5 »m consisting of i-Al_{0.5}Ga_{0.5}As _{w}as grown, and further a protective layer 79 consisting of Si₃N₄ was coated.

Then, Zn and Si were placed by thermal diffusion at either side with a space 2 »m on an upper surface of the protective layer 79, and a p-type region 80 and an n-type region 81 were formed. Subsequently, a cap layer 82 consisting of p⁺-GaAs and an electrode 83 consisting of Cr/Au were created on the upper portion of the p-type area 80, while a cap layer 84 consisting of n⁺-GaAs and an electrode 85 consisting of Au-Ge/Au were created on an upper portion of the n-type area 81.

A reverse bias was applied to the p-i-n structure of horizontal type thus made, and the wavelength characteristic of detected intensity for the incident light was observed in the same way as in the fourth embodiment. As a result, an excellent wavelength selectivity could be obtained like in the fourth embodiment.

As the structure of this embodiment uses a semi-insulating substrate 71, it is easy to electrically isolate from other elements, and is also advantageous for the integration of a plurality of optical couplers, or the integration with an amplifier for detection, a light emitting element, or a control driver.

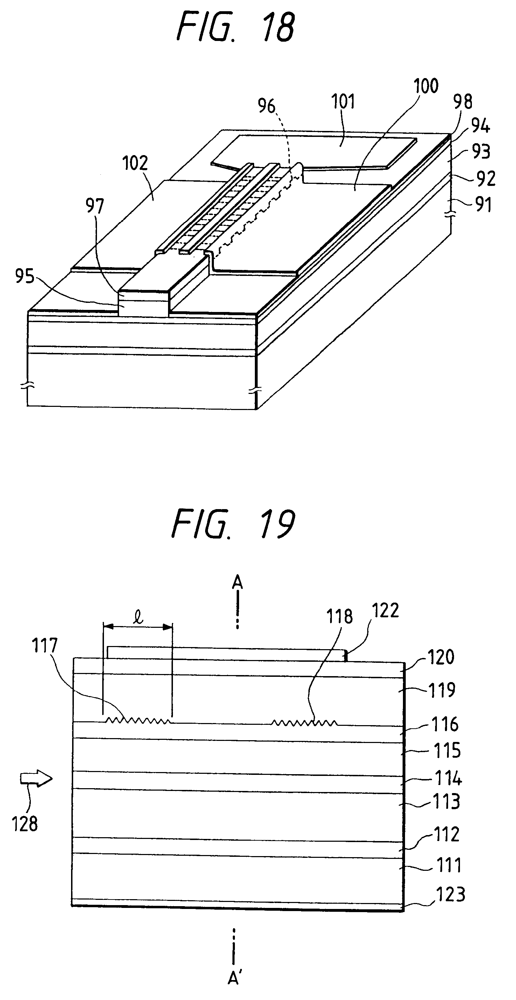

Fig. 18 is a view showing the construction of a sixth embodiment according to this invention. This embodiment has an amplifying feature with the FET structure, besides the wavelength branching detection feature.

In the same way as the fifth embodiment, this embodiment has, in sequence coated by MBE, on a substrate 91 of semi-insulating GaAs, a buffer layer 92 of thickness 0.5 »m consisting of i-GaAs, a cladding layer 93 of thickness 1.5 »m consisting of i-Al_{0.5}Ga_{0.5}As, a waveguide 94 of thickness 0.2 »m constructed in the same way as the waveguide 74 of the fifth embodiment, a cladding layer 95 of thickness 0.6 »m consisting of i-Al_{0.5}As. Then in the same process as for the fourth embodiment, a corrugation-like grating 96 tapered to the intensity of coupling is formed, and subsequently, after a light absorption layer 97 of thickness 0.4 »m consisting of n-GaAs (doping density - 1 x 10¹⁷ cm⁻³) is regrown, an insulating layer 98 of thickness 0.3 »m consisting of Si₃N₄ is coated by sputtering.

Then, as shown, a source electrode 100, a gate electrode 101, and a drain electrode 102 are created on the light absorption layer 97 to make a FET structure. The source electrode 100 and the drain electrode 102 are formed of an Au layer having an undercoating layer of Au-Ge, and the gate electrode 101 is formed of Al.

The operation of this embodiment is performed in the same way as previous embodiments, such that the light incident upon the waveguide 94 is converted in mode in the grating region 96, and absorbed in the light absorption layer 97. Carriers resulting from the absorption are amplified and detected as a drain current.

As this embodiment has the amplifying feature with the FET structure added, in addition to the wavelength detection feature, a photodetector with an excellent detection sensitivity can be obtained.

Also in this embodiment, the layer where the grating 96 is formed may be any region where the guided modes (the even mode 12 and the odd mode 11) that are centred on the light absorption layer 97 or the waveguide 94 overlap.

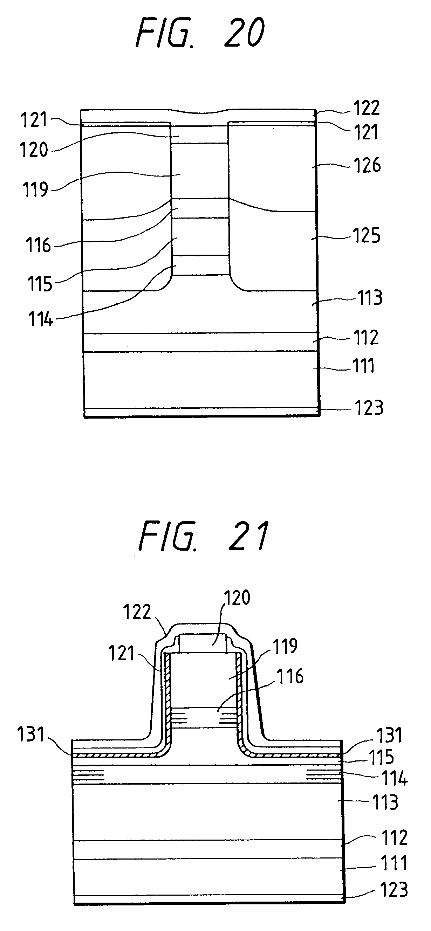

Fig. 19 is a view showing the construction of a seventh embodiment according to this invention, and Fig. 20 is a cross-sectional view taken along line A-A′.

This embodiment has, in sequence grown on a substrate 111 of n-GaAs, a buffer layer 112 consisting of n-GaAs, a first cladding layer 113 of thickness 1.5 »m consisting of n-Al_{0.5}Ga_{0.5}As, a waveguide 114 of thickness 0.2 »m which is constructed a multiple quantum well (MQW) by laminating undoped GaAs and Al_{0.5}Ga_{0.5}As alternatively, a second cladding layer 115 consisting of n-Al_{0.5}Ga_{0.5}As, and an active layer 116 of thickness 0.4 »m which is made a multiple quantum well (MQW) by laminating undoped GaAs and Al_{0.4}Ga_{0.4}As. For the crystal growth in this embodiment, the metal organic chemical deposition (MO-CVD method) was used, but the molecular beam epitaxial method (MBE method) can be also used. The active layer 116 is formed, and then by photolithography, two gratings 117, 118 are formed in spaced portions on its upper surface so as to be appropriate for the wavelength of signal light for the light amplification, and having the same selected wavelength. Then, a third cladding layer 119 of thickness 1.5 »m consisting of p-Al_{0.5}Ga_{0.5}As, a cap layer 120 of thickness 0.2 »m consisting of p⁺-GaAs, and an insulative layer 21 are in sequence formed on the upper portion thereof, and further, a p-type electrode 122 is provided at the portion corresponding to the area between the gratings 117 and 118 on the upper surface of the cap layer 120, and an n-type electrode 123 is provided on the back surface of the substrate 111. The liquid phase epitaxial method (LPE method) was used to make the third cladding layer 119 and the cap layer 120, but the CVD method can be also used.

Then, in order to make the waveguide 114 a three-dimensional structure, both sides of the waveguide 114 are removed by wet etching until the first cladding layer 113 is reached, as shown in Fig. 20, and a buried layer 125 consisting of p-Al_{0.5}Ga_{0.5}As and a buried layer 126 consisting of n-Al_{0.5}Ga_{0.5}As are grown in that removed area, by LPE, to form a buried structure.

In this embodiment having two-layer waveguides (waveguide 114, active layer 116) as shown above, incident light 128 comprising a plurality of laser lights having wavelengths ranging from 0.8 »m to 0.86 »m at intervals of 0.001 »m is coupled for input to the waveguide 114. In this example, in order to perform wavelength filtering with light of 0.83 »m wavelength as the central wavelength, the ratio of ridge to groove changes, in accordance with the Blackman function distribution as shown in Fig. 11, along the progressive direction of light, with the pitch Λ=9 »m from the expression (1) and the complete coupling length L=250 »m from the expression (6).

The signal light transferred from the waveguide 114 to the active layer 116 by the grating 117 the coupling coefficient of which changes in the propagation direction of light is amplified during propagation, as the active layer 116 under the electrode 122 is a laser amplification section having gain. The signal light amplified in propagating through the active layer 116 is coupled to the waveguide 114 again, by the grating 118 formed on the active layer 116, and output from the input/output waveguide 114, as previously described.

Thus, by injecting the current only between the grating 117 and the grating 118, the region of the active layer 116 other than that interval becomes an absorption waveguide, so that the signal input unnecessary for the amplified signal light is eliminated, and spontaneous emission light having a wavelength other than that of the signal resulting from the amplifier can be also removed. In this embodiment, even if the region other than the portion between the gratings 117, 118 is removed by etching, the same effect can be obtained.

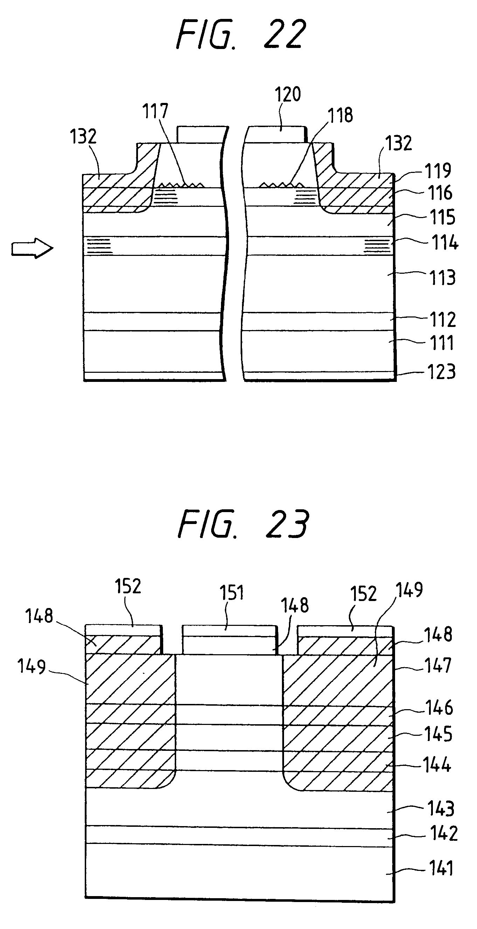

Fig. 21 and Fig. 22 are cross-sectional front and side views, respectively, showing the construction of an eighth embodiment according to the invention. In this eighth embodiment, the light confinement in the transverse direction, which was performed by the buried layers 125, 126 in the seventh embodiment, is performed by removing both sides by etching. The construction of this embodiment is nearly the same as that of the seventh embodiment, wherein like reference numbers designate like parts.

In this embodiment, a third cladding layer 119 is created, and then a three-dimensional waveguide (active layer) 116 as shown is formed, by etching both sides, by reactive ion etching (RIBE or RIE method), until it reaches to the second cladding layer 115 (or first cladding layer 113). Then an impurity diffusion layer 131 is formed by thermal diffusion of the p-type impurities on the etching end surface, and an impurity diffusion layer 132 is formed by the same thermal diffusion on the input/output end surface of the active layer 116, as shown in Fig. 22.

The impurity diffusion layers 131, 132 are intended to disorder both ends of the active layer 116 and the waveguide 114. The reason will be explained in the following. If the three-dimensional waveguide as in this embodiment is formed, the injection carriers are recombined via an interfacial level as a great number of interfacial levels exist on both end portions of the active layer 116, so that invalid injection carriers increase, and the signals light transferred from the waveguide 114 is absorbed.

In this embodiment, the superlattice is disordered in parts of the active layer 116 and the waveguide 114 in the direction normal to the propagation direction of light by the impurity diffusion layer 131, and the superlattice is disordered on a part of the active layer 116 in the direction parallel to the propagation direction of light by the impurity diffusion layer 132. Thereby unnecessary light is not input to the active layer 116, and at the same time, the spontaneous emission light other than the wavelengths of signals that occur in the amplification region can be scattered, whereby the spontaneous emission light is prevented from emitting outside together with the light amplified signal light.

In this way, this embodiment is allowed to make the number of crystal growths less than in the seventh embodiment, and to make a fine adjustment because the width of waveguide can be controlled by the time of the thermal diffusion.

Fig. 23 is a view showing the construction of a ninth embodiment according to this invention. This embodiment has coated on a substrate 141, a buffer layer 142, a first cladding layer 143, a waveguide 144 and a second cladding layer 145, all with GaAs an AlGaAs to which impurities are not doped, unlike the seventh and eighth embodiments. After coating, a grating (not shown) is coated on the active layer 146, and a n-type third cladding layer 147 and a cap layer 148 are regrown. Thereafter, a Si₃N₄ film is formed as a diffusion mask, and further a stripe of about 6 »m width is formed by photolithography, and the n-GaAs cap layer 148 is etched selectively with an etchant consisting of aqueous ammonia and hydrogen peroxide. Then ZnAs and the sample were sealed in vacuum, heated at 650°C for 2.5 hours, and placed by thermal diffusion on the portion where the cap layer 148 on both sides was formed, so that an impurity diffusion layer 149 was formed. The diffusion front at this time may reach to the first cladding layer 143, and both the waveguide 144 and the active layer 146 were disordered by Zn, so that the three-dimensional waveguide was formed. After that, the diffusion mask was removed, the p-type layer diffused on the cap layer 148 was removed by etching, and an insulative film (SiO₂) was formed after a p-type electrode 151 was formed. Further, on the insulative film was formed a through hole, by photolithography, on which an n-type electrode 152 was formed.

The device performance in this embodiment does not differ largely from those of the seventh and eighth embodiments. However, this embodiment has more freedom in designing the devices in fabricating the optical integrated circuits, as undoped layers are used up to the active layer 146.

In this way, the interval between waveguides can be set precisely, by fabricating two waveguides (the active layer 146 and the waveguide 144) in the film direction at the growth of crystal. As the grating is also used such that the ratio of ridge to groove changes along the progressive direction of light in accordance with the distribution of a specific function, the cross talk between the waveguide 144 to which the incident light is input and the active layer 146 can be reduced. And as the design of crystal growth or grating is made easy, optimization of the device can be obtained. As above described, the input/output waveguide 144 and the active layer 146 were made MQWs that were superlattices in the seventh to ninth embodiments, but an ordinary thin film waveguide is satisfactory as well. The structure in which the input/output waveguide 144 is provided on the active layer 146 is also possible.

In order to perform optical amplification for a plurality of wavelengths, a plurality of pairs of gratings 117, 118 having a plurality of different periods and tapered to the intensity of coupling (each pair having a different selective wavelength) can be provided.

As above described, when the grating 117, 118 is formed by corrugation, it is sufficient that the depth of groove (low refractive index region) is increased if the coupling length is required to be shorter. However, if the depth of groove is deepened, the effective layer thickness (mean value of layer thicknesses) for the waveguide formed with the grating, for example, the second waveguide 6 as shown in Fig. 4, changes largely together with the change of the duty ratio. The change of this effective layer thickness has an effect on the selectiveness of wavelength for the guided light. An embodiment according to this invention which further improves the above mentioned inconvenience will be explained in the following.

In the following embodiment, the duty ratio of the grating (the ratio of the high refractive index) region to the low refractive index region in one cycle of the grating) is changed in the propagation direction of light, and one pitch Λ (length of one cycle) of the grating is also gradually changed in the propagation direction of light. Thereby the change of the effective layer thickness in the waveguide where the grating is formed can be suppressed, and an optical device that allows the effective filtering of a desired light can be obtained.

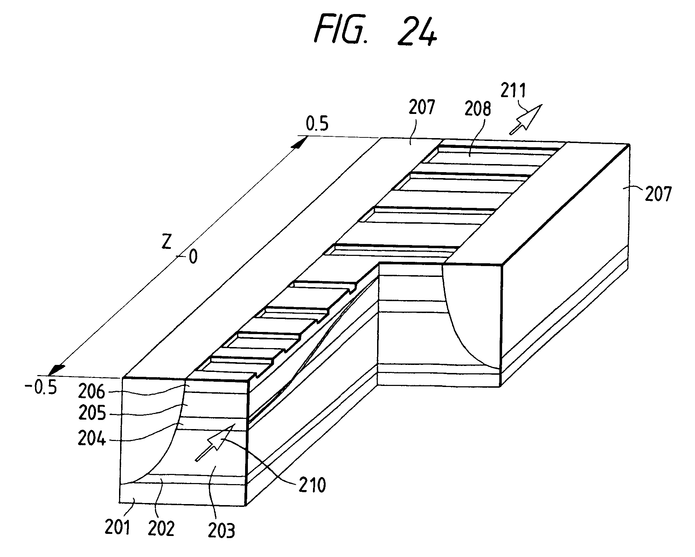

Fig. 24 is a partial cross-sectional perspective view showing a tenth embodiment according to this invention. In the same figure, this embodiment has in sequence grown, with the molecular beam epitaxy (MBE) method, on a substrate 201 of GaAs, a buffer layer 202 of thickness 0.5 »m consisting of GaAs, a cladding layer 203 of thickness 1.5 »m consisting of Al_{0.5}Ga_{0.5}As, a first waveguide 204 which is constructed a multiple quantum well (MQW) by laminating each of nine GaAs layers (30Å) and Al_{0.5}Ga_{0.5}As layers alternately, a cladding layer 205 of thickness 0.8 »m consisting of Al_{0.5}Ga_{0.5}As, and a second waveguide 206 consisting of a multiple quantum well (MQW) constructed by laminating 55 GaAs layers (30Å) and Al_{0.4}Ga_{0.6}As layers (60Å) alternatively and a Al_{0.4}Ga_{0.5}As layer (300Å) on the upper portion of MQW.

Then using photoresist, a stripe of 12 »m in depth is formed, the wafer is etched in a stripe-like form up to the GaAs buffer layer 202, with an etching liquid containing a mixture of sulfuric acid, hydrogen peroxide and water. And after removing the photoresist, the Al_{0.4}Ga_{0.5}As layer 207 is regrown by liquid phase growth, and the stripe is embedded. In this case, as the upper portion of the stripe is the Al_{0.4}Ga_{0.6}As layer (uppermost layer of the second waveguide 206), the Al_{0.5}Ga_{0.5}As is not regrown.

Subsequently, the grating 208 is formed in the direction orthogonal to the above mentioned stripe, using a photo resist. And also using an etching liquid containing a mixture of sulfuric acid, hydrogen peroxide and water, the second waveguide 206 is etched partially, and the grating 208 consisting of corrugations of 700Å in depth is formed. Therefater, by sputtering, SiO₂ is coated on the grating 208. The back surface of the wafer is lapped so that the thickness of wafer may be made 100 »m. Furthermore, this wafer is cut to a predetermined sized, and ZrO₂ is deposited on the input/output end face of the cut wafer to make an anti-reflection coating. Thus the structure with two waveguides 204, 206 laminated as shown in Fig. 24 can be obtained.

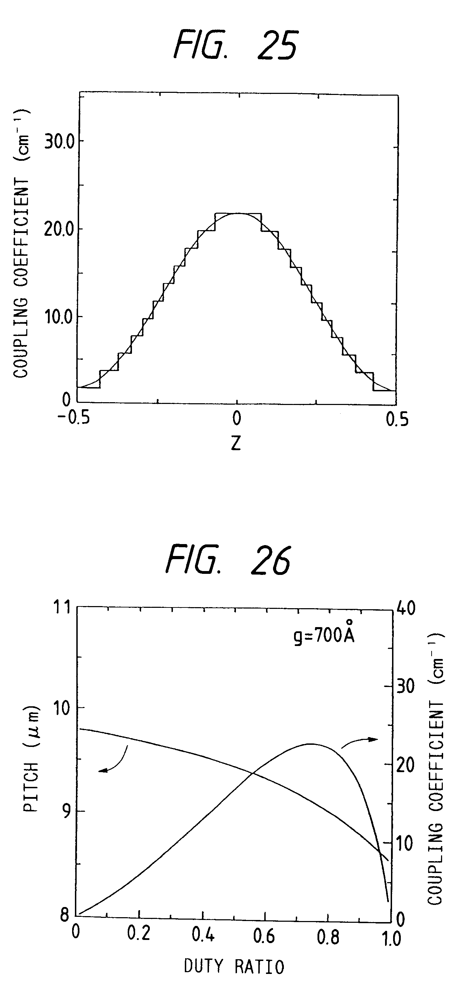

In this embodiment, in order to suppress the side lobe of the filter characteristic, the coupling coefficient of the grating 208 is gradually changed over the coupling area. The distribution of the coupling coefficient changes stepwise depending on the position within the coupling area (shown with a value z normalized to the complete coupling length), as shown with a bold solid line in Fig. 25. The modified embodiment is constructed almost symmetrically along the traveling direction of light from the central portion toward the input and output sides of light. The fine line in Fig. 25 indicates the coupling coefficient of Hamming function F(z) = 1 + 0.852 · cos(2π z/L). The stepwise coupling coefficient of the bold line almost approximates the fine line, and can provide in practice the same effect as the Hamming function, for the distribution of the coupling coefficient.

Such a distribution of the coupling coefficient can be obtained by appropriately distributing the duty ratio (ratio t/Λ occupied by the ridge width t in a pitch Λ) and the pitch Λ of the grating 208 for a specific selected wavelength (in the following explanation, λ₀=0.83 »m).

Fig. 26 shows the pitch and the coupling coefficient to the duty ratio t/Λ of the grating, when the specific selected wavelength λ₀ is selected. The pitch Λ tends to be smaller if the duty ratio is greater, while the coupling coefficient is at maximum near the duty ratio 0.8. This is explained in the following. If the duty ratio is increased, the groove width (portion of groove) of the grating 208 is narrowed, so that the effective thickness of the second waveguide 206 is thicker, and the value of the propagation constant β ₑᵥₑₙ for the even mode of light propagating through the second waveguide 206 is greater. Assuming the propagation constant for the odd mode of light propagating through the first waveguide 204 to be β _{odd}, the pitch Λ of the grating 208 for realizing the phase matching between the even mode and the odd mode can be given by the following expression.${\text{Λ = 2π/(β}}_{\text{even}} {\text{- β}}_{\text{odd}} \text{)}$
Therefore, if β ₑᵥₑₙ is greater, the pitch Λ is smaller.

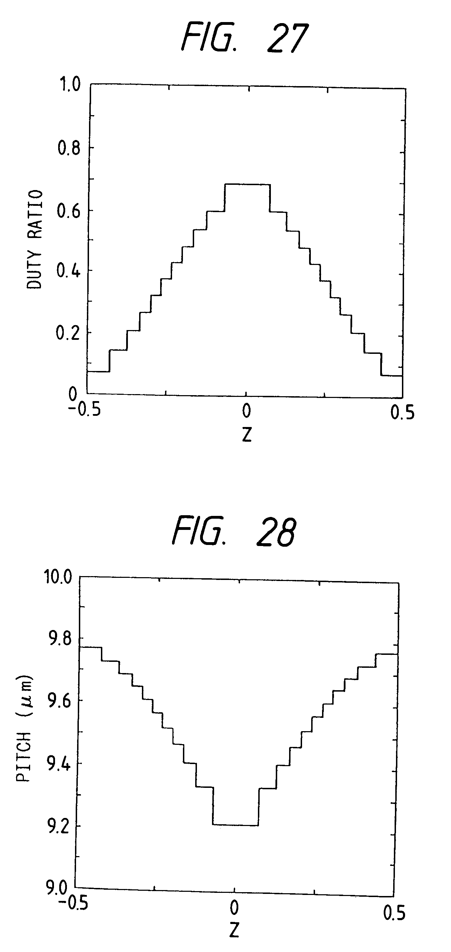

In order to obtain the distribution of the coupling coefficient as shown in Fig. 25, a combination of the duty ratio and the pitch at which a desired coupling coefficient can be obtained at each point of the coupling area is selected from Fig. 24. As a result of such a selection, the duty ratio changes over the entire coupling area, as shown in Fig. 27, to establish the distribution of the coupling coefficient of Fig. 25. And the pitch is distributed over the entire coupling area, as shown in Fig. 28.

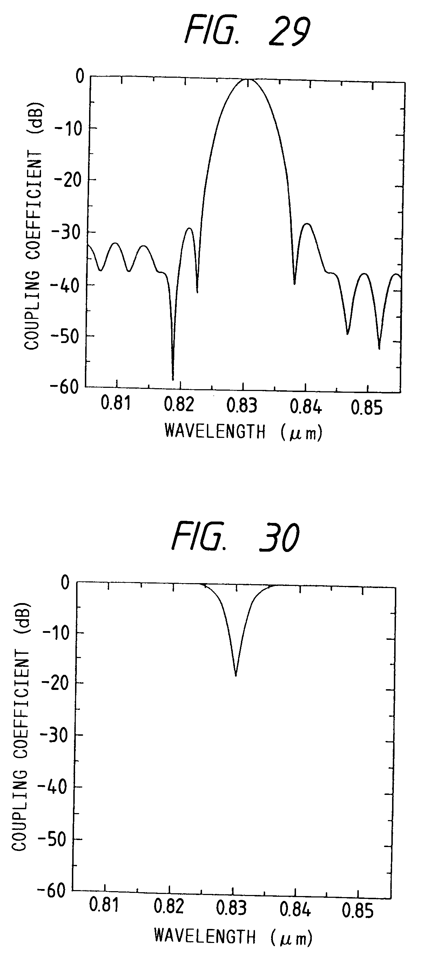

Fig. 29 shows the result of measuring the output light intensity (or the coupling efficiency where the ratio of the intensity of the incoming light at each wavelength to that of the outgoing light is expressed in dB unit) from the second waveguide 206, after introducing light from a tunable light source into the first waveguide 204 of the optical wavelength filter. Thereby it can be seen that the optical wavelength filter of this embodiment has a sufficiently suppressed side lobe, and has a low cross-talk between wavelengths.

On the other hand, Fig. 30 shows the intensity of output light from the first waveguide 204, indicating the notch filter characteristic in which the light does not transmit only at the central wavelength λ₀.

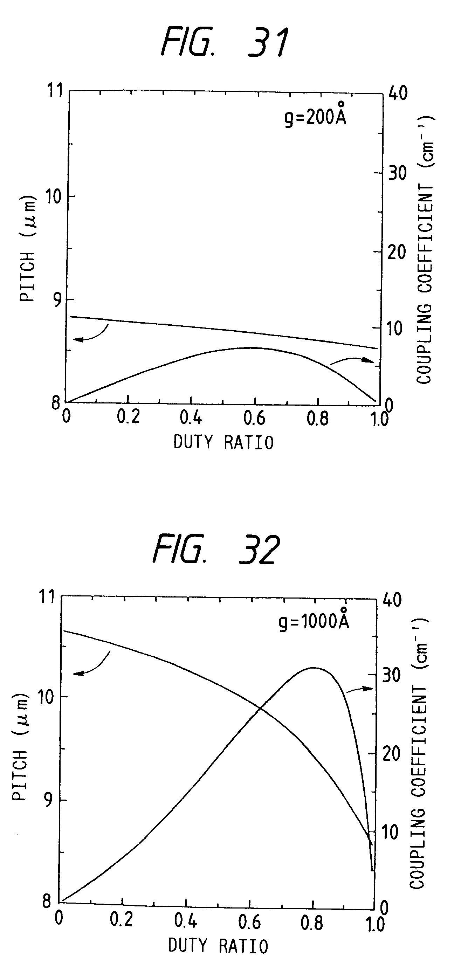

The depth of the grating 208 was 700Å in this embodiment, but when the grating depth is 200Å, for example, the pitch to the duty ratio is almost constant as shown in Fig. 31. Therefore, even though the duty ratio is distributed functionally, the coupling coefficient can be distributed as shown in Fig. 25, to obtain an excellent filter characteristic.

On the contrary, Fig. 32 shows a case where the grating depth is deeper, at 1000Å. As seen, if the grating depth is increased, the pitch must be distributed taperingly to obtain an excellent filter characteristic.

In this way, it should be understood that the distribution of pitch must be considered for a grating depth of 700Å, while it does not have to be considered mainly for a grating depth of 200Å, in the embodiment as shown in Fig. 24. But an appropriate grating depth largely depends on the layer thicknesses or refractive indexes for the waveguides and the cladding layers constituting the filter. Therefore, the duty ratio and the distribution of pitch must be determined so as to attain an excellent filter characteristic corresponding to the grating depth, with the construction of an optical device.

On the contrary, when the pitch is to be changed, an excellent filter characteristic can be obtained, as shown in Fig. 25, by making the distribution of the pitch and the duty ratio appropriate, even though the grating depth is increased to shorten the coupling length.

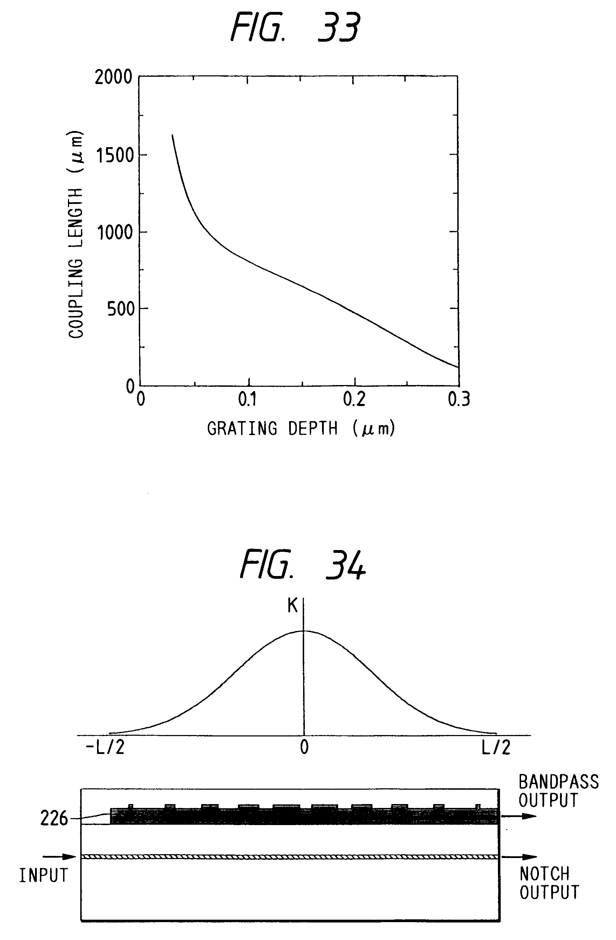

Fig. 33 shows how the coupling length changes when the grating depth is changed. It will be seen that if the grating depth is larger, the coupling coefficient in the coupling area becomes larger, and the coupling length (the length of waveguide required to transfer completely the optical power between waveguides) becomes shorter. As short coupling length is an important factor for integration, the grating depth must be increased if required. According to this invention, even when the grating depth is large, the side lobe can be effectively suppressed by making the distribution of pitch taper-shaped.

Here the operation of the embodiment as shown in Fig. 24 is described. The incident light 210, multiplexed in wavelength ranging from 0.8 »m to 0.86 »m, is coupled for input to the first waveguide 204 of this embodiment. There are two guided modes which exist in two waveguides 204, 206, i.e., the even mode and the odd mode. The incident light 210 to the first waveguide 204 propagates in the odd mode centred on the first waveguide 204. Then as the odd mode and the even mode have different propagation constants, the light propagates nearly independently almost without coupling, in the region where the grating 208 does not exist. However, in the region where the grating 208 exists, the transfer of optical power of wavelength λ occurs if the above expression (9) stands between the propagation constant β _{odd}(λ) for the odd mode and the propagation constant β ₑᵥₑₙ(λ) for the even mode.

If the transfer of optical power occurs, the guided light in the odd mode to which the incident light 210 is coupled can be converted into the guided light in the even mode. Accordingly, the incident light 210 finally becomes the optical wave propagating through the second waveguide 206, and is output as the selected output light 211. The light containing other wavelengths is output from the first waveguide 204 as the unselected output light.

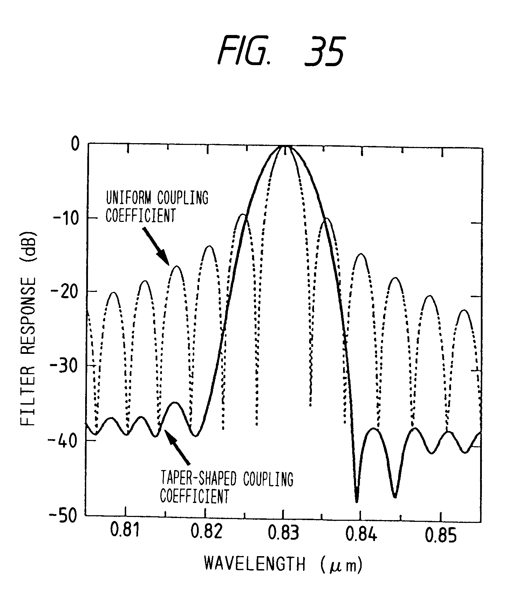

Fig. 34 shows a schematic view of an eleventh embodiment according to this invention, when the distribution of the coupling coefficient κ is a Gauss distribution. The present embodiment is an optical wavelength filter that was created by the same process as the tenth embodiment. The result of measuring the transmitted spectrum from the second waveguide 226 according to this embodiment is shown as a solid line in Fig. 35. Compared with the case of uniform coupling coefficient distribution (indicated with a dashed line), the side lobe is suppressed by 20-25dB. The cross-talk between the central wavelength (λ=0.83»m) and the wavelength 100Å off that central wavelength exceeded -35dB. In Fig. 35, the dashed line indicates the filter response of a comparative example when the coupling coefficient is uniform over the entire coupling area.

The embodiments shown in Fig. 24 and Fig. 25 can be applied to a noise filter integrated with an optical amplifier using the laser structure, an integrated internal filter of the external resonator type laser, or a filter integral with an optical filter. And these embodiments can be formed of III-V group compound semiconductor other than the GaAs group, II-VI group compound semiconductor such as CdTe, or SiO₂, Si₃N₄, LiNbO₃.

## Claims

1. An optical coupling device comprising:
a substrate (1; 21; 31; 51; 71; 91; 111; 141; 201); a first guiding layer (4; 24; 32; 54; 74; 94; 114; 144; 204) provided on said substrate (1; 21; 31; 51; 71; 91; 111; 141; 201);
a second guiding layer (6; 26; 36; 56; 76; 97; 116; 146; 206) laminated with said first guiding layer (4; 24; 34; 54; 74; 94; 114; 144; 204) on said substrate (1; 21; 31; 51; 71; 91; 111; 141; 201), the propagation constant of the guided mode in said second guiding layer (6; 26; 36; 56; 776; 97; 116; 146; 206) being different from that of the guided mode in said first guiding layer (4; 24; 34; 54; 74; 94; 114; 144; 204), said first and second guiding layers being arranged so as to define a propagation direction for light in said guiding layers, and being disposed such that there is an area in which said guided modes overlap; and
a diffraction grating (7; 37; 57; 77; 96; 117; 208) provided in said area of overlap, said diffraction grating (7; 37; 57; 77; 96; 117; 208) acting to couple light of a specific wavelength range propagating through said first guiding layer (4; 24; 34; 54; 74; 94; 114; 144; 204) into said second guiding layer (6; 26; 36; 56; 76; 97; 116; 146; 206), said diffraction grating (7; 37; 57; 77; 96; 117; 208) comprising regions of high refractive index and regions of low refractive index disposed periodically in said light propagation direction;
**characterized in that**
the ratio between the width of the high refractive index region and the width of the low refractive index region within a period of said diffraction grating (7; 37; 57; 77; 96; 117; 208) changes gradually along said light propagation direction.

2. An optical coupling device according to claim 1, **char****acterized in that** said first guiding layer (24) propagates light of multiple wavelengths.

3. An optical coupling device according to claim 1, **characterized by**
a light absorption layer (40) for absorbing at least a part of the light coupled into said second guiding layer (36); and
an electrode (43) for outputting an electrical signal which is converted from the light absorbed by said light absorption layer (40).

4. An optical coupling device according to claim 1, **char****acterized by** said second guiding layer (56; 76; 97) absorbing the light propagating therethrough; and
an electrode (61; 83; 102) for outputting an electrical signal which is converted from the light absorbed by said second guiding layer (56; 76; 97).

5. An optical coupling device according to claim 1, **characterized by** a laser active region provided on at least a part of said second guiding layer (116; 146), said laser active region, when energized, serving to amplify the light propagating through said second guiding layer (116; 146); and
an electrode (122; 151) for supplying current to energize said laser active region.

6. An optical coupling device according to claim 1 or 2, **characterized in that** the pitch of said diffraction grating (7; 37; 57; 77; 96; 117; 208) gradually changes in the light propagation direction.

7. An optical coupling device according to any of the preceding claims 1 to 6, **characterized in that** said diffraction grating (7; 37; 57; 77; 96; 117; 208) is formed such that the coupling coefficient between said first guiding layer (4; 24; 34; 54; 74; 94; 114; 144; 204) and said second guiding layer (6; 26; 36; 56; 76; 97; 116; 146; 206) is high in the central portion of said diffraction grating (7; 37; 57; 77; 96; 117; 208) in the light propagation direction, and is low at both end portions of said diffraction grating (7; 37; 57; 77; 96; 117; 208).

8. An optical coupling device according to claim 7, **characterized in that** said diffraction grating (7; 37; 57; 77; 96; 117; 208) is formed such that the coupling coefficient between said first guiding layer (4; 24; 34; 54; 74; 94; 114; 144; 204) and said second guiding layer (6; 26; 36; 56; 76; 97; 116; 146; 206) is symmetrically distributed with respect to the central portion of said diffraction grating (7; 37; 57; 77; 96; 117; 208) in the light propagation direction.

9. An optical coupling device according to claim 7, **characterized in that** said diffraction grating (7; 37; 57; 77; 96; 117; 208) is formed such that the proportion of one period occupied by said high refractive index region is high in the central portion of said diffraction grating (7; 37; 75; 77; 96; 117; 118; 208) in the light propagation direction, and is low at both end portions of said diffraction grating (7; 37; 57; 77; 96; 117; 208).

10. An optical coupling device according to claim 9, **char****acterized in that** said diffraction grating (7; 37; 57; 77; 96; 117; 208) consists of a corrugation formed on said second guiding layer (6; 26; 36; 56; 76; 97; 116; 146; 206) and is formed such that the proportion of one period of said corrugation occupied by the ridge portion is high in the central portion of said diffraction grating (7; 37; 57; 77; 96; 117; 208) in the light propagation direction, and is low at both end portions of said diffraction grating (7; 37; 57; 77; 96; 117; 208).

11. An optical coupling device according to claim 7, **char****acterized in that,** assuming the complete coupling length between said first guiding layer (4; 24; 34; 54; 74; 94; 114; 144; 204) and said second guiding layer (6; 26; 36; 56; 76; 97; 116; 146; 206) to be L, the progressive direction of light to be the z direction, the coupling coeffizient which changes in the z direction to be G(z), the taper function for distributing the coupling coefficient G(z) to be F(z), and Gₒ to be a constant, the following relation is satisfied, 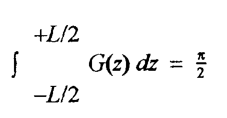 $\text{G(z)} \text{=} \text{G} \text{₀ ·} \text{F(z} \text{)}$

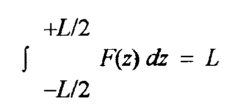

12. An optical coupling device according to claim 11, **characterized in that** the taper function F(z) is a Hamming function as expressed in the following$\text{F} \text{(} \text{z} \text{) = 1 + 0.852 · cos (2π} \text{z} \text{/} \text{L} \text{)}$

13. An optical coupling device according to claim 11, **characterized in that** said taper function F(z) is a Black-man function as expressed in the following$\text{F} \text{(} \text{z} \text{) = 1 + 1.19 · cos (2π} \text{z} \text{/} \text{L} \text{) + 1.19 · cos (4π} \text{z} \text{/} \text{L} \text{)}$

14. An optical coupling device according to claim 11, **characterized in that** said taper function F(z) is a raised cosine function as expressed in the following$\text{F} \text{(} \text{z} \text{) = 1 + cos (2π} \text{z} \text{/} \text{L} \text{)}$

15. An optical coupling device according to claim 11, **characterized in that** said taper function F(z) is a Kaiser function as expressed in the following 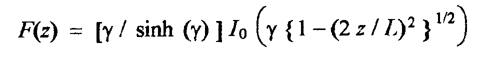 wherein γ is an arbitrary number, and *I*_{*o*} is the zero order value of the Bessel function of the first kind.

16. An optical coupling device according to any of the preceding claims 1 to 6, **characterized in that**, when the wavelength of said propagating light is λ, the propagation constant in the guided mode for said first guiding layer (4; 24; 34; 54; 74; 94; 114; 144; 204) is β₀(λ), the propagation constant in the guided mode for said second guiding layer (6; 26; 36; 56; 76; 97; 116; 146; 206) is β₁(λ), and said pitch of said diffraction grating (7; 37; 57; 77; 96; 117; 208) is Λ, the following expression is satisfied,$\text{β₁ (λ) - β₀ (λ) = 2π/Λ}$

17. An optical coupling device according to any of the preceding claims 1 to 6, **characterized by** further comprising first, second and third cladding layers, and sequentially laminating said first cladding layer (3; 23; 33; 53; 73; 93; 113; 143; 203), said first guiding layer (4; 24; 34; 54; 74; 94; 114; 144; 204), said second cladding layer (5; 25; 35; 55; 75; 95; 115; 145; 205), said second guiding layer (6; 26; 36; 56; 76; 97; 116; 146; 206), and said third cladding layer (27; 38; 58; 78; 119; 147) on said substrate (1; 21; 31; 51; 71; 91; 111; 141; 201).

18. An optical coupling device according to claim 17, **characterized in that** said substrate (1; 21; 31; 51; 71; 91; 111; 141; 201) and each of said layers consist of GaAs or AlGaAs.

19. An optical coupling device according to claim 18, **characterized in that** said first and second guiding layers have multiple quantum wells.

20. An optical coupling device according to claim 3, **char****acterized in that** said light absorption layer (40) is provided in series with said second guiding layer (36) in the light propagation direction.

21. An optical coupling device according to claim 3, **characterized in that** said light absorption layer (40) consists of an i-type semiconductor, on either side of which a p-type semiconductor and a n-type semiconductor are provided, and said optical coupling device constitutes a PIN photodiode.

22. An optical coupling device according to claim 17 as dependent on claim 4, **characterized in that** said first guiding layer (54), first and second cladding layers (53, 55) are semiconductors having a first conductivity type, said third cladding layer (58) is a semiconductor having a second conductivity type, and said second guiding layer (56) consists of an i-type seminconductor so that said optical coupling device constitutes a PIN photodiode.

23. An optical coupling device according to claim 22, **characterized in that** said first conductivity type is n-type, and said second conductivity type is p-type.

24. An optical coupling device according to claim 17 as dependent on claim 4,
**characterized in that**
said substrate (71) is a semi-insulative semiconductor, said first and second guiding layers (74, 76), said first, second and third cladding layers (73, 75, 78) consist of i-type semiconductors, and
on a part of laminate containing those layers is formed a stripe-shaped region extending in the light propagation direction, on either side of which p-type and n-type regions (80, 81) are formed, so that that optical coupling device constitutes a PIN photodiode.

25. An optical coupling device according to claim 17, as dependent on claim 4,
**characterized in that**
said substrate (91) is a semi-insulative semiconductor, said first guiding layer (94), first, second and third cladding layers (93, 95) consist of i-type semiconductors, said second guiding layer (97) consists of a n-type semiconductor,
on a part of laminate containing those layers is formed a stripe-shaped region extending in the propagation direction of light, on both sides of which are formed p-type and n-type regions, with which a source electrode (100) and a drain electrode (102) are contacted respectively, and
on said third cladding layer of said stripe region is formed an insulating layer (98), on which a gate electrode (101) is provided.

26. An optical coupling device according to claim 25, **characterized in that** said diffraction grating (96) consists of corrugation formed on said second cladding layer (95).

27. An optical coupling device according to claim 5, **characterized in that** a second diffraction grating (118), similar to said diffraction grating (117), is provided in said area of overlap, said two diffraction gratings (117, 118) are spaced by a predetermined distance in the light propagation direction, such that the light propagation through said first guiding layer (114) is coupled to said second guiding layer (116) by one of said diffraction gratings (117), and the coupled light propagating through said second guiding layer (116) is coupled to said first guiding layer (114) again by said other of said diffraction gratings (118).

28. An optical coupling device according to claim 27, **characterized in that** impurities are diffused in said second guiding layer (116) in an area located other than between said two diffraction gratings (117, 118).

29. An optical coupling device according to claim 17 as dependent on claim 5, **characterized in that** said first cladding layer (113), first guiding layer (114), second cladding layer (115), second guiding layer (116) and third cladding layer (119) have a mesa etching, except for a stripe-shaped region extending in the propagation direction of light, on both sides of which is formed a buried layer (125, 126).

30. An optical coupling device according to claim 17 as dependent on claim 5, **characterized in that** said second cladding layer (115), second guiding layer (116) and third cladding layer (119) are formed with stripe-shaped ridges extending in the propagation direction of light by etching.

## Patentansprüche

1. Optische Kopplungsvorrichtung mit:
Einem Substrat (1; 21; 31; 51; 71; 91; 111; 141; 201); einer ersten Führungsschicht (4; 24; 32; 54; 74; 94; 114; 144; 204), die auf dem Substrat (1; 21; 31; 51; 71; 91; 111; 141; 201) bereitgestellt ist;
einer zweiten Führungsschicht (6; 26; 36; 56; 76; 97; 116; 146; 206), die mit der ersten Führungsschicht (4; 24; 34; 54; 74; 94; 114; 144; 204) auf dem Substrat (1; 21; 31; 51; 71; 91; 111; 141; 201) laminiert ist, wobei die Ausbreitungskonstante der geführten Mode in der zweiten Führungsschicht (6; 26; 36; 56; 76; 97; 116; 146; 206) verschieden von der der geführten Mode in der ersten Führungsschicht (4; 24; 34; 54; 74; 94; 114; 144; 204) ist und die erste und die zweite Führungsschicht so angeordnet sind, daß sie eine Ausbreitungsrichtung für Licht in den Führungsschichten definieren und so angeordnet sind, daß es einen Bereich gibt, in dem die geführten Moden überlappen; und
einem Beugungsgitter (7; 37; 57; 77; 96; 117; 208), das in dem Überlappungsgebiet bereitgestellt ist, wobei das Beugungsgitter (7; 37; 57; 77; 96; 117; 208) wirkt, indem es Licht mit einem spezifischen Wellenlängenbereich, das sich durch die erste Führungsschicht (4; 24; 34; 54; 74; 94; 114; 144; 204) ausbreitet, in die zweite Führungsschicht (6; 26; 36; 56; 76; 97; 116; 146; 206) einkoppelt, wobei das Beugungsgitter (7; 37; 57; 77; 96; 117; 208) Bereiche mit hohem Brechungsindex und Bereiche mit niedrigem Brechungsindex umfaßt, die periodisch in der Licht-Ausbreitungsrichtung angeordnet sind; dadurch gekennzeichnet, daß das Verhältnis zwischen der Breite des Bereiches mit hohem Brechungsindex und der Breite des Bereichs mit niedrigem Brechungsindex innerhalb einer Periode des Beugungsgitters (7; 37; 57; 77; 96; 117; 208) sich graduell entlang der Lichtausbreitungsrichtung verändert.

2. Optische Kopplungsvorrichtung nach Anspruch 1, dadurch gekennzeichnet, daß sich in der ersten Führungsschicht (24) Licht mit vielfachen Wellenlängen ausbreitet.

3. Optische Kopplungsvorrichtung nach Anspruch 1, gekennzeichnet durch eine Lichtabsorptionsschicht (40) zum Absorbieren von mindestens einem Teil des Lichtes, das in die zweite Führungsschicht (36) gekoppelt wird; und eine Elektrode (43) zum Ausgeben eines elektrischen Signals, das aus dem durch die Lichtabsorptionsschicht (40) absorbierten Licht umgewandelt worden ist.

4. Optische Kopplungsvorrichtung nach Anspruch 1, gekennzeichnet durch die zweite Führungsschicht (56, 76, 97), die das sich durch sie ausbreitende Licht absorbiert; und durch eine Elektrode (61; 83; 102) zum Ausgeben eines elektrischen Signals, das aus dem durch die zweite Führungsschicht (56; 76; 97) absorbierten Licht umgewandelt worden ist.

5. Optische Kopplungsvorrichtung nach Anspruch 1, gekennzeichnet durch einen aktiven Laser-Bereich, der auf mindestens einem Teil der zweiten Führungsschicht (116; 146) bereitgestellt ist, wobei der aktive Laser-Bereich, wenn angeregt, dazu dient, das sich durch die zweite Führungsschicht (116; 146) ausbreitende Licht zu verstärken; und eine Elektrode (121; 151) zum Zuführen von Strom, um den aktiven Laser-Bereich anzuregen.

6. Optische Kopplungsvorrichtung nach einem der Ansprüche 1 oder 2, dadurch gekennzeichnet, daß der Abstand des Beugungsgitters (7; 37; 57; 77; 96; 117; 208) sich in der Ausbreitungsrichtung des Lichts graduell verändert.

7. Optische Kopplungsvorrichtung nach einem der vorhergehenden Ansprüche 1 bis 6, dadurch gekennzeichnet, daß das Beugungsgitter (7; 37; 57; 77; 96; 117; 208) so gebildet ist, daß der Kopplungkoeffizient zwischen der ersten Führungsschicht (4; 24; 34; 54; 74; 94; 114; 144; 204) und der zweiten Führungsschicht (6; 26; 36; 56; 76; 97; 116; 146; 206) in dem zentralen Bereich des Beugungsgitters (7; 37; 57; 77; 96; 117; 208) in der Ausbreitungsrichtung von Licht hoch ist und an beiden Endbereichen des Beugungsgitters (7; 37; 57; 77; 96; 117; 208) niedrig ist.

8. Optische Kopplungsvorrichtung nach Anspruch 7, dadurch gekennzeichnet, daß das Beugungsgitter (7; 37; 57; 77; 96; 117; 208) so gebildet ist, daß der Kopplungskoeffizient zwischen der ersten Führungsschicht (4, 24; 34; 54; 74; 94; 114; 144; 204) und der zweiten Führungsschicht (6; 26; 36; 56; 76; 97; 116; 146; 206) symmetrisch in Bezug auf den Zentralbereich des Beugungsgitters (7; 37; 57; 77; 96; 117; 208) in der Ausbreitungsrichtung des Lichts verteilt ist.

9. Optische Kopplungsvorrichtung nach Anspruch 7, dadurch gekennzeichnet, daß das Beugungsgitter (7; 37; 57; 77; 96; 117; 208) so gebildet ist, daß der Anteil von einer Periode, der von dem Bereich mit hohem Brechungsindex belegt wird, in dem Zentralbereich des Beugungsgitters (7; 37; 57; 77; 96; 117; 118; 208) in der Lichtausbreitungsrichtung hoch ist und an beiden Endbereichen des Beugungsgitters (7; 37; 57; 77; 96; 117; 208) niedrig ist.

10. Optische Kopplungsvorrichtung nach Anspruch 9, dadurch gekennzeichnet, daß das Beugungsgitter (7; 37; 57; 77; 96; 117; 208) aus einer Riffelung besteht, die auf der zweiten Führungsschicht (6; 26; 36; 56; 76; 97; 116; 146; 206) gebildet ist, und so gebildet ist, daß der Anteil von einer Periode der Riffelung, der von dem Stegbereich belegt wird, in dem Zentralbereich des Beugungsgitters (7; 37; 57; 77; 96; 117; 208) in der Lichtausbreitungsrichtung hoch ist und an beiden Endbereichen des Beugungsgitters (7; 37; 57, 77; 96; 117; 208) niedrig ist.

11. Optische Kopplungsvorrichtung nach Anspruch 7, dadurch gekennzeichnet, daß unter der Annahme, daß die vollständige Kopplungslänge zwischen der ersten Führungsschicht (4; 24; 34; 54; 74; 94; 114; 144; 204) und der zweiten Führungsschicht (6; 26; 36; 56; 76; 97; 116; 146; 206) L ist, die Ausbreitungsrichtung von Licht die z-Richtung ist, der Kopplungskoeffizient, der sich in der z-Richtung verändert, G(z) ist, die Kegel-Funktion für die Verteilung des Kopplungskoeffizienten G(z) F(z) ist und G₀ eine Konstante ist, die folgende Beziehung erfüllt ist 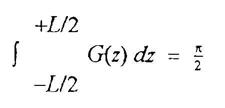 $\text{G} \text{(} \text{z} \text{) =} \text{G} \text{₀ ·} \text{F} \text{(} \text{z} \text{)}$

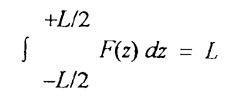

12. Optische Kopplungsvorrichtung nach Anspruch 11, dadurch gekennzeichnet, daß die Kegel-Funktion F(z) eine Hamming-Funktion ist, wie im folgenden ausgedrückt$\text{F(z) = 1 + 0,852 · cos(2π z/L)}$

13. Optische Kopplungsvorrichtung nach Anspruch 11, dadurch gekennzeichnet, daß die Kegel-Funktion F(z) eine Blackman-Funktion ist, wie im folgenden ausgedrückt$\text{F(z) = 1 + 1,19 · cos(2π z/L) + 1,19 · cos(4π z/L)}$

14. Optische Kopplungsvorrichtung nach Anspruch 11, dadurch gekennzeichnet, daß die Kegel-Funktion F(z) eine erhöhte Cosinus-Funktion ist, wie im folgenden ausgedrückt$\text{F(z) = 1 + cos(2π z/L)}$

15. Optische Kopplungsvorrichtung nach Anspruch 11, dadurch gekennzeichnet, daß die Kegel-Funktion F(z) eine Kaiser-Funktion ist, wie im folgenden ausgedrückt${\text{F(z) = [γ/sinh(γ)] I₀(γ{1-(2z/L)²}}}^{\text{1/2}} \text{),}$ worin γ eine beliebige Zahl ist, und I₀ der Wert mullter Ordnung der Bessel-Funktion der ersten Art ist.

16. Optische Kopplungsvorrichtung nach einem der vorhergehenden Ansprüche 1 bis 6, dadurch gekennzeichnet, daß, wenn die Wellenlänge des sich ausbreitenden Lichtes λ ist, die Ausbreitungskonstante in der geführten Mode für die erste Führungsschicht (4; 24; 34; 54; 74; 94; 114; 144; 204) β₀(λ) ist, die Ausbreitungskonstante in der geführten Mode für die zweite Führungsschicht (6; 26; 36; 56; 76; 97; 116; 146; 206) β₁(λ) ist und der Abstand des Beugungsgitters (7; 37; 57; 77; 96; 117; 208) Λ ist, die folgende Gleichung erfüllt ist$\text{β₁(λ) - β₀(λ) = 2π/Λ}$

17. Optische Kopplungsvorrichtung nach einem der vorhergehenden Ansprüche 1 bis 6, dadurch gekennzeichnet, daß sie ferner erste, zweite und dritte Mantelschichten umfaßt, und daß die erste Mantelschicht (3; 23; 33; 53; 73; 93; 113; 143; 203), die erste Führungsschicht (4; 24; 34; 54; 74; 94; 114; 144; 204), die zweite Mantelschicht (5; 25; 35; 55; 75; 95; 115; 145; 205), die zweite Führungsschicht (6; 26; 36; 56; 76; 97; 116; 146; 206) und die dritte Mantelschicht (27; 38; 58; 78; 119; 147) auf dem Substrat (1; 21; 31; 51; 71; 91; 111; 141; 201) aufeinanderfolgend laminiert sind.

18. Optische Kopplungsvorrichtung nach Anspruch 17, dadurch gekennzeichnet, daß das Substrat (1; 21; 31; 51; 71; 91; 111; 141; 201) und jede der Schichten aus GaAs oder AlGaAs besteht.

19. Optische Kopplungsvorrichtung nach Anspruch 18, dadurch gekennzeichnet, daß die erste und zweite Führungsschicht Vielfach-Quantentöpfe haben.

20. Optische Kopplungsvorrichtung nach Anspruch 3, dadurch gekennzeichnet, daß die Lichtabsorptionsschicht (40) in Reihe mit der zweiten Führungsschicht (36) in der Ausbreitungsrichtung des Lichts bereitgestellt ist.

21. Optische Kopplungsvorrichtung nach Anspruch 3, dadurch gekennzeichnet, daß die Lichtabsorptionsschicht (40) aus einem i-Typ-Halbleiter besteht, an dessen beiden Seiten ein p-Typ-Halbleiter und ein n-Typ-Halbleiter bereitgestellt sind, und daß die optische Kopplungsvorrichtung eine PIN-Photodiode darstellt.

22. Optische Kopplungsvorrichtung nach Anspruch 17, der auf Anspruch 4 zurückbezogen ist, dadurch gekennzeichnet, daß die erste Führungsschicht (54), die erste und die zweite Mantelschicht (53, 55) Halbleiter mit einem ersten Leitfähigkeitstyp sind, die dritte Mantelschicht (58) ein Halbleiter mit einem zweiten Leitfähigkeitstyp ist und die zweite Führungsschicht (56) aus einem i-Typ-Halbleiter besteht, so daß die optische Kopplungsvorrichtung eine PIN-Photodiode darstellt.

23. Optische Kopplungsvorrichtung nach Anspruch 22, dadurch gekennzeichnet, daß der erste Leitfähigkeitstyp n-Typ ist und der zweite Leitfähigkeitstyp p-Typ ist.

24. Optische Kopplungsvorrichtung nach Anspruch 17, der auf Anspruch 4 zurückbezogen ist, dadurch gekennzeichnet, daß das Substrat (71) ein halbisolierender Halbleiter ist, die erste und zweite Führungsschicht (74, 76), die erste, zweite und dritte Mantelschicht (73, 75, 78) aus i-Typ-Halbleitern bestehen, und auf einem Teil des Laminats, das diese Schichten enthält, ein streifenförmiger Bereich gebildet ist, der sich in der Lichtausbreitungsrichtung erstreckt, auf dessen beiden Seiten p-Typ- und n-Typ-Bereiche (80, 81) gebildet sind, so daß die optische Kopplungsvorrichtung eine PIN-Photodiode darstellt.

25. Optische Kopplungsvorrichtung nach Anspruch 17, der auf Anspruch 4 zurückbezogen ist, dadurch gekennzeichnet, daß das Substrat (91) ein halbisolierender Halbleiter ist, die erste Führungsschicht (94), die erste, zweite und dritte Mantelschicht (93, 95) aus i-Typ-Halbleitern bestehen, die zweite Führungsschicht (97) aus einem n-Typ-Halbleiter besteht, auf einem Teil des Laminats, das diese Schichten enthält, ein streifenförmiger Bereich gebildet ist, der sich in die Ausbreitungsrichtung von Licht erstreckt, auf dessen beiden Seiten p-Typ- und n-Typ-Bereiche gebildet sind, mit denen eine Source-Elektrode (100) und eine Drain-Elektrode (102) jeweils in Kontakt gebracht sind, und daß auf der dritten Mantelschicht des Streifenbereichs eine isolierende Schicht (98) gebildet ist, auf der eine Gate-Elektrode (101) bereitgestellt ist.

26. Optische Kopplungsvorrichtung nach Anspruch 25, dadurch gekennzeichnet, daß das Beugungsgitter (96) aus Riffelungen besteht, die auf der zweiten Mantelschicht (95) gebildet sind.

27. Optische Kopplungsvorrichtung nach Anspruch 5, dadurch gekennzeichnet, daß ein zweites Beugungsgitter (118) ähnlich dem ersten Beugungsgitter (117) in dem Überlappungsgebiet bereitgestellt ist, wobei die zwei Beugungsgitter (117, 118) um einen vorbestimmten Abstand in der Lichtausbreitungsrichtung auseinanderliegen, so daß das Licht, das sich durch die erste Führungsschicht (114) ausbreitet, an die zweite Führungsschicht (116) durch eines der Beugungsgitter (117) gekoppelt wird, und das sich durch die zweite Führungsschicht (116) ausbreitende Licht an die erste Führungsschicht (114) wiederum durch das andere der Beugungsgitter (118) gekoppelt wird.

28. Optische Kopplungsvorrichtung nach Anspruch 27, dadurch gekennzeichnet, daß Verunreinigungen in der zweiten Führungsschicht (116) in einen Bereich diffundiert sind, der sich außerhalb der zwei Beugungsgitter (117, 118) befindet.

29. Optische Kopplungsvorrichtung nach Anspruch 17, der auf Anspruch 5 zurückbezogen ist, dadurch gekennzeichnet, daß die erste Mantelschicht (113), die erste Führungsschicht (114), die zweite Mantelschicht (115), die zweite Führungsschicht (116) und die dritte Mantelschicht (119) eine geätzte Mesa haben, außer eines streifenförmigen Bereichs, der sich in der Ausbreitungsrichtung von Licht erstreckt, auf deren beiden Seiten eine vergrabene Schicht (125, 126) gebildet ist.

30. Optische Kopplungsvorrichtung nach Anspruch 17, der auf Anspruch 5 zurückbezogen ist, dadurch gekennzeichnet, daß die zweite Mantelschicht (115), die zweite Führungsschicht (116) und die dritte Mantelschicht (119) mit streifenförmigen Stegen, die sich in der Ausbreitungsrichtung von Licht erstrecken, durch Ätzen gebildet sind.

## Revendications

1. Dispositif de couplage optique comprenant:
un substrat (1; 21; 31; 51; 71; 91; 111; 141; 201);
une première couche de guidage (4; 24; 32; 54; 74; 94; 114; 144; 204) disposée sur ledit substrat (1; 21; 31; 51; 71; 91; 111; 141; 201);
une deuxième couche de guidage (6; 26; 36; 56; 76; 97; 116; 146; 206) stratifiée avec ladite première couche de guidage (4; 24; 34; 54; 74; 94; 114; 144; 204) sur ledit substrat (1; 21; 31; 51; 71; 91; 111; 141; 201), la constante de propagation du mode guidé dans ladite deuxième couche de guidage (6; 26; 36; 56; 76; 97; 116; 146; 206) étant différente de celle du mode guidé dans ladite première couche de guidage (4; 24; 34; 54; 74; 94; 114; 144; 204), lesdites première et deuxième couches de guidage étant agencées de façon à définir une direction de propagation de la lumière dans lesdites couches de guidage, et étant disposées de façon qu'il existe une zone dans laquelle lesdits modes guidés se chevauchent; et
un réseau de diffraction (7; 37; 57; 77; 96; 117; 208) disposé dans ladite zone de chevauchement, ledit réseau de diffraction (7; 37; 57; 77; 96; 117; 208) ayant pour effet de coupler une lumière ayant une gamme spécifique de longueurs d'onde se propageant à travers ladite première couche de guidage (4; 24; 32; 54; 74; 94; 114; 144; 204), dans ladite deuxième couche de guidage (6; 26; 36; 56; 76; 97; 116; 146; 206), ledit réseau de diffraction (7; 37; 57; 77; 96; 117; 208) comprenant des régions à fort indice de réfraction et des régions à faible indice de réfraction disposées périodiquement dans ladite direction de propagation de la lumière;
caractérisé en ce que
le rapport entre la largeur de la région à fort indice de réfraction et la largeur de la région à faible indice de réfraction à l'intérieur d'une période dudit réseau de diffraction (7; 37; 57; 77; 96; 117; 208) varie progressivement suivant ladite direction de propagation de la lumière.

2. Dispositif de couplage optique selon la revendication 1, caractérisé en ce que ladite première couche (24) de guidage fait se propager une lumière ayant des longueurs d'onde multiples.

3. Dispositif de couplage optique selon la revendication 1, caractérisé par:
une couche (40) d'absorption de la lumière pour absorber au moins une partie de la lumière couplée dans ladite deuxième couche (36) de guidage; et
une électrode (43) pour fournir en sortie un signal électrique qui est converti à partir de la lumière absorbée par ladite couche (40) d'absorption de la lumière.

4. Dispositif de couplage optique selon la revendication 1, caractérisé par:
le fait que ladite deuxième couche (56; 76; 97) de guidage absorbe la lumière se propageant à travers celle-ci; et
une électrode (61; 83; 102) pour fournir en sortie un signal électrique qui est converti à partir de la lumière absorbée par ladite deuxième couche (56; 76; 97) de guidage.

5. Dispositif de couplage optique selon la revendication 1, caractérisé par une région à effet laser réalisée sur au moins une partie de ladite deuxième couche (116; 146) de guidage, ladite région à effet laser, lorsqu'elle est activée, servant à amplifier la lumière se propageant à travers ladite deuxième couche (116; 146) de guidage; et
une électrode (122; 151) pour fournir un courant afin d'activer ladite région à effet laser.

6. Dispositif de couplage optique selon les revendications 1 ou 2, caractérisé en ce que le pas dudit réseau de diffraction (7; 37; 57; 77; 96; 117; 208) varie progressivement dans la direction de propagation de la lumière.

7. Dispositif de couplage optique selon l'une quelconque des revendications 1 à 6 précédentes, caractérisé en ce que ledit réseau de diffraction (7; 37; 57; 77; 96; 117; 208) est formé de façon que le coefficient de couplage entre ladite première couche de guidage (4; 24; 32; 54; 74; 94; 114; 144; 204) et ladite deuxième couche de guidage (6; 26; 36; 56; 76; 97; 116; 146; 206) soit élevé dans la partie centrale du réseau de diffraction (7; 37; 57; 77; 96; 117; 208), dans la direction de propagation de la lumière, et soit faible dans les deux parties d'extrémité dudit réseau de diffraction (7; 37; 57; 77; 96; 117; 208).

8. Dispositif de couplage optique selon la revendication 7, caractérisé en ce que ledit réseau de diffraction (7; 37; 57; 77; 96; 117; 208) est formé de façon que le coefficient de couplage entre ladite première couche de guidage (4; 24; 34; 54; 74; 94; 114; 144; 204) et ladite deuxième couche de guidage (6; 26; 36; 56; 76; 97; 116; 146; 206) est réparti symétriquement par rapport à la partie centrale dudit réseau de diffraction (7; 37; 57; 77; 96; 117; 208), dans la direction de propagation de la lumière.

9. Dispositif de couplage optique selon la revendication 7, caractérisé en ce que ledit réseau de diffraction (7; 37; 57; 77; 96; 117; 208) est formé de façon que ladite proportion d'une période qui est occupée par ladite région à fort indice de réfraction soit élevée dans la partie centrale dudit réseau de diffraction (7; 37; 57; 77; 96; 117; 208), dans la direction de propagation de la lumière, et soit faible aux deux parties d'extrémité dudit réseau de diffraction (7; 37; 57; 77; 96; 117; 208).

10. Dispositif de couplage optique selon la revendication 9, caractérisé en ce que ledit réseau de diffraction (7; 37; 57; 77; 96; 117; 208) est constitué de stries formées sur ladite deuxième couche de guidage (6; 26; 36; 56; 76; 97; 116; 146; 206) et est formé de façon que la proportion d'une période desdites stries qui est occupée par la partie formant nervure, soit élevée dans la partie centrale dudit réseau de diffraction (7; 37; 57; 77; 96; 117; 208), dans la direction de propagation de la lumière, et soit faible aux deux parties d'extrémité dudit réseau de diffraction (7; 37; 57; 77; 96; 117; 208).

11. Dispositif de couplage optique selon la revendication 7, caractérisé en ce que, si l'on suppose que la longueur de couplage complète entre ladite première couche de guidage (4; 24; 34; 54; 74; 94; 114; 144; 204) et ladite deuxième couche de guidage (6; 26; 36; 56; 76; 97; 116; 146; 206) est égale à L, que le sens progressif de la lumière est la direction z, que le coefficient de couplage qui varie dans la direction z est G(z), que la fonction de biseau servant à répartir le coefficient de couplage G(z) est F(z), et que G₀ est une constante, la relation suivante est satisfaite, 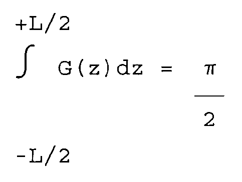 $\text{G(z) = G₀ x F(z)}$

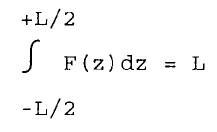

12. Dispositif de couplage optique selon la revendication 11, caractérisé en ce que la fonction de biseau F(z) est une fonction de Hamming s'exprimant de la façon suivante:$\text{F(z) = 1 + 0,852 x cos (2π z/L)}$

13. Dispositif de couplage optique selon la revendication 11, caractérisé en ce que ladite fonction de biseau F(z) est une fonction de Blackman s'exprimant de la façon suivante:$\text{F(z) = 1 + 1,19 x cos (2} \text{π} \text{z/L) + 1,19 x cos (4} \text{π} \text{z/L)}$

14. Dispositif de couplage optique selon la revendication 11, caractérisé en ce que ladite fonction de biseau F(z) est une fonction cosinus surélevé s'exprimant de la façon suivante:$\text{F(z) = 1 + cos (2π z/L)}$

15. Dispositif de couplage optique selon la revendication 11, caractérisé en ce que ladite fonction de biseau F(z) est une fonction de Kaiser s'exprimant de la façon suivante:$\text{F(z) = [} \text{γ} \text{/sinh (γ)] I₀(} \text{γ} {\text{{1- (2z/L)²})}}^{\text{1/2}}$ où ***γ*** est un nombre arbitraire et I₀ est la valeur d'ordre zéro de la fonction de Bessel du premier genre.

16. Dispositif de couplage optique selon l'une quelconque des revendications 1 à 6 précédentes, caractérisé en ce que, lorsque la longueur d'onde de ladite lumière se propageant est λ, lorsque la constante de propagation en mode guidé pour ladite première couche de guidage (4; 24; 34; 54; 74; 94; 114; 144; 204) est β₀(λ), lorsque la constante de propagation en mode guidé pour ladite deuxième couche de guidage (6; 26; 36; 56; 76; 97; 116; 146; 206) est β₁(λ) et lorsque le pas dudit réseau de diffraction (7; 37; 57; 77; 96; 117; 208) est Λ, l'expression suivante est satisfaite$\text{β} \text{₁(} \text{λ} \text{) -} \text{β} \text{₀(} \text{λ} \text{) = 2} \text{π} \text{/} \text{Λ}$

17. Dispositif de couplage optique selon l'une quelconque des revendications 1 à 6 précédentes, caractérisé par le fait qu'il comprend en outre des première, deuxième et troisième couches de placage, et par le fait qu'on stratifie séquentiellement ladite première couche de placage (3; 23; 33; 53; 73; 93; 113; 143; 203), ladite première couche de guidage (4; 24; 34; 54; 74; 94; 114; 144; 204) , ladite deuxième couche de placage (5; 25; 35; 55; 75; 95; 115; 145; 205), ladite deuxième couche de guidage (6; 26; 36; 56; 76; 97; 116; 146; 206), et ladite troisième couche de placage (27; 38; 58; 78; 119; 147) sur ledit substrat (1; 21; 31; 51; 71; 91; 111; 141; 201).

18. Dispositif de couplage optique selon la revendication 17, caractérisé en ce que ledit substrat (1; 21; 31; 51; 71; 91; 111; 141; 201) et chacune desdites couches sont constitués de GaAs ou d'AlGaAs.

19. Dispositif de couplage optique selon la revendication 18, caractérisé en ce que lesdites première et deuxième couches de guidage ont des puits quantiques multiples.

20. Dispositif de couplage optique selon la revendication 3, caractérisé en ce que ladite couche (40) absorbant la lumière est réalisée en série avec ladite deuxième couche (36) de guidage dans la direction de propagation de la lumière.

21. Dispositif de couplage optique selon la revendication 3, caractérisé en ce que ladite couche (40) d'absorption de la lumière est constituée d'un semiconducteur de type i de chaque côté duquel sont réalisés un semiconducteur du type p et un semiconducteur de type n et en ce que ledit dispositif de couplage optique constitue une photodiode PIN.

22. Dispositif de couplage optique selon la revendication 17, lorsqu'elle dépend de la revendication 4, caractérisé en ce que ladite première couche (54) de guidage et lesdites première et deuxième couches (53, 55) de placage sont des semiconducteurs ayant un premier type de conductivité, et en ce que ladite troisième couche (58) de placage est un semiconducteur ayant un deuxième type de conductivité et en ce que ladite deuxième couche (56) de guidage est constituée d'un semiconducteur de type i de façon que ledit dispositif de couplage optique constitue une photodiode PIN.

23. Dispositif de couplage optique selon la revendication 22, caractérisé en ce que ledit premier type de conductivité est le type n et en ce que ledit deuxième type de conductivité est le type p.

24. Dispositif de couplage optique selon la revendication 17, lorsqu'elle dépend de la revendication 4, caractérisé en ce que
ledit substrat (71) est un semiconducteur semi-isolant, lesdites première et deuxième couches (74, 76) de guidage, et en ce que lesdites première, deuxième et troisième couches (73, 75, 78) de placage sont constituées de semi-conducteur de type i, et
en ce que, sur une partie du stratifié contenant ces couches est formée une région en bandes s'étendant dans la direction de propagation de la lumière, de chaque côté de laquelle des régions (80, 81) de type p et de type n sont formées de façon que le dispositif de couplage optique constitue une photodiode PIN.

25. Dispositif de couplage optique selon la revendication 17, lorsqu'elle dépend de la revendication 4, caractérisé en ce que
ledit substrat (91) est un semiconducteur semi-isolant,
en ce que ladite première couche (94) de guidage, lesdites première, deuxième et troisième couches (93, 95) de placage sont constituées de semi-conducteurs de type i,
en ce que ladite deuxième couche (97) de guidage est constituée d'un semiconducteur de type n,
en ce que, sur une partie du stratifié contenant ces couches, est formée une région en bandes s'étendant dans la direction de propagation de la lumière, de chaque côté de laquelle sont formées des région de type p et de type n avec lesquelles sont respectivement mises en contact une électrode (100) de source et une électrode (102) de drain, et
en ce que, sur ladite troisième couche de placage de ladite région en bandes, est formée une couche (98) isolante, sur laquelle une électrode (101) de grille est réalisée.

26. Dispositif de couplage optique selon la revendication 25, caractérisé en ce que ledit réseau (96) de diffraction est constitué de stries formées sur ladite deuxième couche (95) de placage.

27. Dispositif de couplage optique selon la revendication 5, caractérisé en ce qu'un deuxième réseau de diffraction (118), semblable audit réseau de diffraction (117) est réalisé dans ladite zone de chevauchement, et en ce que lesdits deux réseaux de diffraction (117, 118) sont espacés d'une distance prédéterminée dans la direction de propagation de la lumière, de façon que la lumière se propageant à travers ladite première couche (114) de guidage soit couplée vers ladite deuxième couche (116) de guidage par l'un desdits réseaux (117) de diffraction, et que la lumière couplée se propageant à travers ladite deuxième couche (116) de guidage soit de nouveau couplée vers ladite première couche (114) de guidage par ledit autre desdits réseaux de diffraction (118).

28. Dispositif de couplage optique selon la revendication 27, caractérisé en ce que des impuretés sont diffusées dans ladite deuxième couche (116) de guidage, dans une zone située ailleurs qu'entre lesdits deux réseaux de diffraction (117, 118).

29. Dispositif de couplage optique selon la revendication 17, lorsqu'elle dépend de la revendication 5, caractérisé en ce que ladite première couche (113) de placage, ladite première couche (114) de guidage, ladite deuxième couche (115) de placage, ladite deuxième couche (116) de guidage et ladite troisième couche (119) de placage ont une gravure mesa, à l'exception d'une région en bandes s'étendant dans la direction de propagation de la lumière, de chaque côté de laquelle est formée une couche (125, 126) enterrée.

30. Dispositif de couplage optique selon la revendication 17, lorsqu'elle dépend de la revendication 5, caractérisé en ce que ladite deuxième couche (115) de placage, ladite deuxième couche (116) de guidage et ladite troisième couche (119) de placage, sont munies par gravure de nervures en forme de bandes, s'étendant dans la direction de propagation de la lumière.
